# EUROPEAN PATENT APPLICATION

(11) **EP 4 239 029 A1**
(43) Date of publication of application: **06.09.2023**
(21) Application number: 21886440.3
(22) Date of filing: 02.11.2021
(51) Int. Cl.: C08L 101/00, C01B 39/48, C08K 3/013, C08K 3/34, C08L 63/00, H01L 23/29, H01L 23/31

(54) **ZEOLITE, METHOD FOR PRODUCING ZEOLITE, COMPOSITION, LIQUID COMPOSITION, LIQUID SEALING AGENT, RESIN COMPOSITE MATERIAL, SEALING MATERIAL, METHOD FOR MANUFATUCTRING SEALING MATERIAL, AND DEVICE**

(30) Priority: 02.11.2020 JP 2020183582
(71) Applicant: Mitsubishi Chemical Corporation, Chiyoda-ku Tokyo 100-8251 (JP)
(72) Inventor: OHNISHI, Ryohji, Tokyo 100-8251 (JP); MATSUNAGA, Chie, Tokyo 100-8251 (JP); KATAGIRI, Noriko, Tokyo 100-8251 (JP); IKEDA, Masashi, Tokyo 100-8251 (JP); MATSUI, Jun, Tokyo 100-8251 (JP); TAKEWAKI, Takahiko, Tokyo 100-8251 (JP)
(74) Representative: Hoffmann Eitle
(86) International application number: PCT/JP2021/040454
(87) International publication number: WO 2022/092323

(57) **Abstract**

Provided is a liquid composition containing a resin and an inorganic filler, in which the inorganic filler contains a zeolite having a particle size of 1.0 µm or more and 10 µm or less and an inorganic filler having a particle size of 0.1 µm or more and less than 1.0 µm. It is possible to provide a liquid composition capable of lowering viscosity while lowering the thermal expansion coefficient of a cured product.

## Description

### Technical Field

The present invention relates to a zeolite, a method for producing a zeolite, a composition, a liquid composition, a liquid sealing agent, a resin composite material, a sealing material, a method for producing a sealing material, and an electronic device.

### Background Art

A liquid sealing agent used as an underfill material is required to be excellent in injectability, adhesiveness, curability, storage stability, and the like, and not to generate voids. In addition, a portion sealed with the liquid sealing agent is required to be excellent in moisture resistance, thermal cycle resistance, reflow resistance, crack resistance, warpage resistance, and the like. In order to satisfy the above requirements, a liquid sealing agent containing an epoxy resin as a main ingredient has been widely used as a liquid sealing agent used as the underfill material.

In addition, in order to improve the moisture resistance and the thermal cycle resistance of the portion sealed by the liquid sealing agent, in particular, the thermal cycle resistance, it is known that by adding a filler made of an inorganic substance such as a silica filler (hereinafter referred to as an "inorganic filler") to the liquid sealing agent, it is effective to control a difference in thermal expansion coefficient between a substrate made of an organic material such as an epoxy resin and a semiconductor element or to reinforce a bump electrode (see PTL 1).

### Citation List

### Patent Literature

PTL 1: JP 2007-56070 A

### Summary of Invention

### Technical Problem

A liquid sealing agent using an inorganic filler such as a silica filler does not have a sufficiently low thermal expansion coefficient, and from the viewpoint of thermal cycle resistance and the like, it is required to further lower the thermal expansion coefficient. In addition, a zeolite is known as an inorganic filler having a low thermal expansion coefficient, but a liquid composition in which the zeolite is blended tends to have a high viscosity, and the injectability when used as an underfill material is reduced, and therefore, it is difficult to obtain a liquid sealing agent having good injectability while lowering the thermal expansion coefficient of a cured product.

In view of the above, an object of the present invention is to provide a liquid composition capable of lowering the thermal expansion coefficient of a cured product, and an epoxy resin composite material obtained by curing the liquid composition.

In addition, an object of the present invention is to provide a liquid composition in which a zeolite is blended, which is capable of preventing an increase in viscosity, and an epoxy resin composite material obtained from the liquid composition.

Further, in the case of a zeolite having a lower thermal expansion coefficient, the thermal expansion coefficient of the resin composite material can be reduced with a smaller amount, and suppression of an increase in viscosity due to the use of the zeolite can be expected, and therefore, it is also an object of the present invention to provide a zeolite having a lower thermal expansion coefficient. Furthermore, it is also an object of the present invention to provide various applications in which suppression of thermal expansion is required, such as a resin substrate using a zeolite having a low thermal expansion coefficient.

### Solution to Problem

The gist of the present invention is as follows.
[1] A liquid composition containing a resin and an inorganic filler, in which the inorganic filler contains a zeolite having a particle size of 1.0 µm or more and 10 µm or less and an inorganic filler having a particle size of 0.1 µm or more and less than 1.0 µm.
[2] The liquid composition as set forth in [1], further containing a dispersant having at least one functional group of an amino group and an amine salt.
[3] The liquid composition as set forth in [1] or [2], in which the zeolite has d6r as CBU.
[4] The liquid composition as set forth in any of [1] to [3], in which the zeolite is an aluminosilicate.
[5] The liquid composition as set forth in any of [1] to [4], in which the resin is an epoxy resin.
[6] The liquid composition as set forth in any of [1] to [5], in which the resin is an epoxy resin, and the liquid composition has a viscosity at 23°C of 0.1 Pa ·s or more and 250 Pa ·s or less.
[7] A liquid sealing agent containing the liquid composition as set forth in any of [1] to [6].
[8] A resin composite material obtained by curing the liquid composition as set forth in any of [1] to [6] to have a gel fraction of 80% or more.
[9] A resin composite material containing a resin and an inorganic filler, in which the inorganic filler contains a zeolite having a particle size of 1.0 µm or more and 10 µm or less and an inorganic filler having a particle size of 0.1 µm or more and less than 1.0 µm.
[10] The resin composite material as set forth in [9], further containing a dispersant having at least one functional group of an amino group and an amine salt.
[11] The resin composite material as set forth in [9] or [10], in which the zeolite has d6r as CBU.
[12] The resin composite material as set forth in any of [9] to [11], in which the zeolite is an aluminosilicate.
[13] The resin composite material as set forth in any of [9] to [12], in which the resin is at least one selected from the group consisting of an epoxy resin and a polyimide resin.
[14] The resin composite material as set forth in any of [9] to [13], in which the resin is an epoxy resin, and an average thermal expansion coefficient obtained by the following method is 0 ppm/K or more and 200 ppm/K or less (in which the average thermal expansion coefficient is obtained from a slope of a tangent line obtained by measuring a temperature change of a change amount of sample lengths at 25 to 100°C by a compression method based on thermomechanical analysis in accordance with JIS K 7197 (2012)).
[15] A zeolite which is a spherical aluminosilicate having a particle size of 1.0 µm or more and 10 µm or less, and having d6r as CBU.
[16] A zeolite which is an aluminosilicate having a particle size of 1.0 pm or more and 10 µm or less, having d6r as CBU, and having a c-axis length of a lattice constant of 14.80 Å or less.
[17] A composition containing the zeolite as set forth in [15] or [16] and a resin.
[18] The composition as set forth in [17], in which the resin is at least one selected from the group consisting of an epoxy resin and a polyimide resin.
[19] The composition as set forth in [17] or [18], further containing an inorganic filler having a particle size of 0.1 µm or more and less than 1.0 µm.
[20] The composition as set forth in any of [17] to [19], further containing a dispersant having at least one functional group of an amino group and an amine salt.
[21] The liquid composition as set forth in any of [17] to [20], in which a content of the zeolite is 40 to 70% by mass, the resin is an epoxy resin, and the liquid composition has a viscosity at 23°C of 1 Pa ·s or more and 30 Pa ·s or less.
[22] A resin composite material containing the composition as set forth in any of [17] to [20], in which a content of the zeolite is 40 to 70% by mass, the resin is an epoxy resin, and an average thermal expansion coefficient at 25 to 100°C is 10 to 30 ppm/K.
[23] A sealing material containing the resin composite material as set forth in any of [9] to [14] and [22].
[24] An electronic device including the resin composite material as set forth in any of [9] to [14] and [22].
[25] A method for producing a sealing material, including filling a gap with the liquid composition as set forth in any of [1] to [6] and [21], and then curing the liquid composition.
[26] A method for producing a zeolite, including a step of hydrothermally synthesizing a raw material composition containing a silicon atom raw material, a water-soluble aluminum atom raw material, an organic structure directing agent, and water, and a step of subsequently firing the raw material composition, in which the raw material composition contains 0.05 mol or less of alkali metal atoms other than the organic structure directing agent with respect to 1 mol of Si atoms.

### Advantageous Effects of Invention

In the present invention, by using a combination of a zeolite and an inorganic filler each having a specific particle size, it is possible to provide a liquid composition in which the viscosity does not easily increase, and a resin composite material having a reduced thermal expansion coefficient obtained by curing the liquid composition.

In addition, in the present invention, by using a specific dispersant, it is possible to provide a liquid composition in which an increase in viscosity is prevented in a liquid composition in which a zeolite is blended, and a resin composite material obtained from the liquid composition.

Further, it is also possible to provide a zeolite having a low thermal expansion coefficient, which is suitable for suppressing thermal expansion of a resin.

### Brief Description of Drawings

Fig. 1 is a chart showing the particle size distribution of the zeolite of Example 1.
Fig. 2 is a chart showing the particle size distribution of the zeolite of Example 2.
Fig. 3 is a chart showing the particle size distribution of the zeolite of Comparative Example 2.

### Description of Embodiments

Hereinafter, the present invention will be described with reference to embodiments.

### [First Embodiment]

### <Zeolite>

The zeolite according to the first embodiment of the present invention is an aluminosilicate having a particle size of 1.0 µm or more and 10 µm or less and containing d6r as CBU.

One of the features of the zeolite of the present invention is that the particle size is larger than that of ordinary zeolite, and the particle size is 1.0 µm or more and 10 µm or less.

Hereinafter, the zeolite according to the first embodiment of the present invention will be described in detail. The zeolite having a particle size of 1.0 µm or more and 10 µm or less may be hereinafter referred to as "large particle size zeolite".

### (Particle Size of Zeolite)

The particle size of the zeolite according to the first embodiment of the present invention means a diameter (circle equivalent diameter) of a circle having an area equal to a projected area of the particle and having a maximum diameter in observation of the particle with a scanning electron microscope (SEM). In the zeolite according to the first embodiment of the present invention, a plurality of zeolite particles may be aggregated to form a secondary particle. In this case, the particle size of the zeolite is the particle size of the primary particles.

When the zeolite according to the first embodiment of the present invention is added to a resin, the particle size of the zeolite is preferably large from the viewpoint that the viscosity of the resin hardly increases. On the other hand, the particle size of the zeolite is preferably small from the viewpoint that the zeolite is easily uniformly mixed with other components such as the resin and the surface smoothness is easily increased. Specifically, the particle size is preferably 1.5 µm or more, and more preferably 2.0 µm or more. On the other hand, the particle size is preferably 8 µm or less, and more preferably 5 µm or less.

When the zeolite is used, it is usually used as a group of a plurality of zeolite particles instead of one zeolite particle. That is, in one aspect of the present invention, it is preferably used as a zeolite group containing at least the zeolite particle according to the first embodiment of the present invention. The average primary particle size of the zeolite in one aspect composed of such a plurality of zeolite particles is preferably in the range of 1.1 to 4.0 µm, more preferably 1.5 to 3.8 µm, and still more preferably 2.0 to 3.5 µm. The average primary particle size of the zeolite is obtained by randomly selecting 50 particles of the zeolite (powder, particles in a liquid composition or a resin composite material to be described later), measuring the particle sizes thereof, and calculating the average value thereof.

As for the volume-based particle size distribution of the zeolite, the median diameter (d50) is preferably in the range of 0.5 to 5.0 µm, more preferably in the range of 1.5 to 5.0 µm, and still more preferably in the range of 2.0 to 4.0 µm. When the median diameter is within this range, the ratio of the zeolite that exhibits the effect of the present invention is increased, and the effect of the present invention is easily obtained with a smaller amount.

### (Structure of Zeolite)

Zeolite is a compound containing silicon or aluminum and oxygen and having a TO₄ unit (T element is an element other than oxygen constituting the skeleton) as a basic unit. Specific examples of the zeolite include a crystalline porous aluminosilicate, a crystalline porous aluminophosphate (ALPO), or a crystalline porous silicoaluminophosphate (SAPO). The zeolite according to the first embodiment of the present invention is an aluminosilicate.

Zeolite is composed of a structural unit called Composite Building Unit (hereinafter, may be referred to as "CBU") in which several (several to several tens) TO₄ units are connected. Therefore, it has regular channels (tubular pores) and cavities.

The CBU and the crystal structure of the zeolite to be described later can be represented by a code that defines the structure of the zeolite defined by the International Zeolite Association (IZA). The structure of the zeolite can be identified by using a Zeolite Structure Database, 2018 edition (http://www.iza-structure.org/databases/) on the basis of an X-ray diffraction pattern obtained by an X-ray structure analyzer (for example, a table-top X-ray diffractometer D2 PHASER manufactured by BRUKER Corporation).

### (Framework of Zeolite)

The framework of the zeolite according to the first embodiment of the present invention has d6r as CBU. By having d6r, it is easy to obtain a resin composite material having a low thermal expansion coefficient, which will be described in detail later.

Examples of the zeolite having d6r as CBU include zeolites having AEI, AFT, AFV, AFX, AVL, CHA, EAB, EMT, ERI, FAU, GME, JSR, KFI, LEV, LTL, LTN, MOZ, MSO, MWW, OFF, SAS, SAT, SAV, SBS, SBT, SFW, SSF, SZR, TSC, or -WEN type structure.

Among these, a zeolite having a structure of an 8-membered oxygen ring or less is particularly preferable from the viewpoint of easily controlling the particle size. Examples of the zeolite having a structure of an 8-membered oxygen ring or less include zeolites having AEI, AFT, AFX, CHA, ERI, KFI, SAT, SAV, SFW, or TSC type structure. Among these, zeolites having AEI, AFX, CHA, and ERI type structures are more preferable, and a zeolite having a CHA structure is most preferable because the structure is stable even when the shape is controlled. In the description herein, the structure having an 8-membered oxygen ring means a structure in which the number of oxygen elements is 8 in the case where the number of oxygen is the largest in the pores composed of oxygen forming the zeolite framework and the T element (element other than oxygen constituting the framework).

### (Average Thermal Expansion Coefficient of Zeolite)

The average thermal expansion coefficient of the zeolite according to the first embodiment of the present invention is preferably low because it is easy to reduce the average thermal expansion coefficient of a liquid composition and a resin composite material, which will be described later, with a small amount. In addition, when the amount is small, various physical properties of the resin are not easily changed by the addition of the zeolite, which is also preferable. In particular, from the viewpoint of being able to suppress an increase in the viscosity of the liquid composition which will be described later, the average thermal expansion coefficient of the zeolite is preferably low. To be specific, the average thermal expansion coefficient of the zeolite is usually less than 0 ppm/K, preferably -2 ppm/K or less, more preferably -3 ppm/K or less, still more preferably -5 ppm/K or less, particularly preferably -6 ppm/K or less, and most preferably -8 ppm/K or less.

On the other hand, in consideration of a liquid composition and a resin composite material containing a zeolite and a resin, which will be described later, the average thermal expansion coefficient of the zeolite is preferably high from the viewpoint that the difference between the average thermal expansion coefficient of the zeolite and the average thermal expansion coefficient of the resin is small and the zeolite and the resin are hardly peeled off. Therefore, the average thermal expansion coefficient of the zeolite is usually -1000 ppm/K or more, preferably -900 ppm/K or more, more preferably -800 ppm/K or more, still more preferably -700 ppm/K or more, particularly preferably -500 ppm/K or more, and even more preferably -300 ppm/K or more. In particular, when it is used in an application in contact with other materials such as a sealing material and a substrate, the thermal expansion coefficient is preferably high, and concretely, it is preferably -100 ppm/K or more, more preferably -50 ppm/K or more, still more preferably -40 ppm/K or more, particularly preferably -30 ppm/K or more, even more preferably -25 ppm/K or more, and most preferably -20 ppm/K or more.

The average thermal expansion coefficient of the zeolite can be measured by calculating lattice constants using an X-ray diffractometer "D8 ADVANCE" manufactured by BRUKER Corporation and X-ray diffraction analysis software "JADE". Here, in order to remove the influence of moisture desorption, the measurement is performed in a state where the zeolite is dried.

The measurement of the average thermal expansion coefficient of a zeolite is usually performed in a range of 50 to 100°C. That is, the average thermal expansion coefficient is a numerical value representing a displacement of the lattice constants per 1°C from the average lattice constants at 50°C and the average lattice constants at 100°C when a zeolite is heated. Here, the average lattice constants at the respective temperatures are average values of the lattice constants of the a-axis, the b-axis, and the c-axis. The measurement of the average thermal expansion coefficient is performed by gradually raising the temperature after waiting until the lattice constants are stabilized.

In general, a resin often has a large thermal expansion coefficient in a high temperature range. Therefore, it is preferable that the average thermal expansion coefficient of the zeolite is low particularly when the temperature is increased to a high temperature region. To be specific, the average thermal expansion coefficient (high temperature region) in the range of 50 to 350°C is preferably -9.5 ppm/K or less, more preferably -10.0 ppm/K or less, and still more preferably -12.5 ppm/K or less. Here, the average thermal expansion coefficient (high temperature region) of the zeolite is a numerical value representing a displacement of the lattice constants per 1°C from the average lattice constants at 50°C and the average lattice constants at 350°C when zeolite is heated.

### (Shape of Zeolite)

The shape of the zeolite according to the first embodiment of the present invention is preferably a spherical shape because it is easy to contain the zeolite while suppressing an increase in viscosity. Specifically, it is preferable to have the following sphericity and roundness.

### <<Sphericity>>

The sphericity of the zeolite is preferably 0.6 or more, more preferably 0.65 or more, and particularly preferably 0.70 or more. The upper limit of the sphericity is not particularly limited, and may be 1 or less. In addition, the sphericity in the case of a cubic shape, which is common in a zeolite, is 0.58.

In the description herein, "sphericity" is defined as "the ratio of the minimum diameter to the maximum diameter of a particle". Each of the maximum diameter and the minimum diameter can be determined by observation with a scanning electron microscope (SEM).

### <<Roundness>>

The roundness of the zeolite according to the first embodiment of the present invention is preferably 0.786 or more, more preferably 0.790 or more, still more preferably 0.795 or more, even more preferably 0.800 or more, yet still more preferably 0.805 or more, particularly preferably 0.810 or more, yet even more preferably 0.815 or more, and most preferably 0.820 or more. The upper limit of the roundness is not particularly limited, and may be 1 or less. In addition, the roundness in the case of a cubic shape, which is common in a zeolite, is 0.785.

In the description herein, "roundness" is defined as "4 × π × area/(circumference)²". The area and the circumference can be obtained by observation with a scanning electron microscope (SEM).

### (c-Axis Length of Zeolite)

In the zeolite according to the first embodiment of the present invention, the c-axis length of the lattice constant is preferably short. It is considered that since the c-axis length is short, lateral lattice vibration becomes large, negative expansion occurs, and thus the average thermal expansion coefficient is likely to be low. Specifically, the c-axis length is preferably 14.80 Å or less, more preferably 14.78 Å or less, still more preferably 14.76 Å or less, particularly preferably 14.74 Å or less, even more preferably 14.72 Å or less, and most preferably 14.70 Å or less.

In the description herein, the c-axis length refers to the length of the c-axis at room temperature (23°C). The lattice constants of the zeolite can be measured by using an X-ray diffractometer "D8 ADVANCE" manufactured by BRUKER Corporation, and can be calculated by least-squares method using X-ray diffraction analysis software "JADE".

### (Framework Density of Zeolite)

The framework density of the zeolite according to the first embodiment of the present invention is not particularly limited as long as the effects of the present invention are not impaired. The framework density of the zeolite is preferably low from the viewpoint that structural vibration of the zeolite is likely to occur and the average thermal expansion coefficient is likely to be low. Therefore, the framework density of the zeolite is preferably 17.0 T/1000 Å³ or less, and more preferably 16.0 T/1000 Å³ or less.

On the other hand, the framework density of the zeolite is preferably high from the viewpoint that the structural stability of the zeolite is likely to be high. Therefore, the framework density of the zeolite is preferably 12.0 T/1000 Å³ or more, more preferably 13.0 T/1000 Å³ or more, and still more preferably 14.0 T/1000 Å³ or more. When the framework density is within the above range, the zeolite can be used as a stable filler.

The framework density indicates the number of T atoms present per unit volume of the zeolite, and is a value determined by the structure of the zeolite. In the description herein, numerical values described in IZA Zeolite Structure Database, 2017 edition (http://www.iza-structure.org/databases/) may be used.

Examples of the zeolite having a framework density of more than 16.0 T/1000 Å³ and 17.0 T/1000 Å³ or less include zeolites having ERI, LTL, LTN, MOZ, OFF, SAT, SSF, and -WEN type structures.

Examples of the zeolite having a framework density of more than 15.0 T/1000 Å³ and 16.0 T/1000 Å³ or less include zeolites having AEI, AFT, AFV, AFX, AVL, EAB, GME, LEV, MWW, or SFW type structure.

Examples of the zeolite having a framework density of more than 14.0 T/1000 Å³ and 15.0 T/1000 Å³ or less include zeolites having CHA, KFI, SAS, or SAV type structure.

Examples of the zeolite in which the framework density is in the range of 14.0 T/1000 Å³ or less include zeolites having EMT, FAU, JSR, SBS, SBT, or TSC type structure.

### (Silica/Alumina Molar Ratio (SAR) of Zeolite)

The silica/alumina molar ratio (which may be referred to as "SAR", "Si/Al₂ molar ratio", or "Si/Al₂ ratio") of the zeolite according to the first embodiment of the present invention is not particularly limited as long as the effects of the present invention are not impaired. The SAR (Si/Al₂ ratio) of the zeolite is preferably high from the viewpoint that the moisture resistance of the resin composite material described later becomes high and the amount of the counter cation is easily controlled. Therefore, the SAR (Si/Al₂ ratio) of the zeolite is usually 2 or more, preferably 3 or more, more preferably 3.5 or more, still more preferably 4 or more, particularly preferably 4.5 or more, and most preferably 5 or more.

On the other hand, the SAR (Si/Al₂ ratio) of the zeolite is preferably low from the viewpoint of being easily produced at low cost. Therefore, the SAR (Si/Al₂ ratio) of the zeolite is usually 2000 or less, preferably 1000 or less, more preferably 500 or less, and still more preferably 100 or less. When the Si/Al₂ ratio is within the above range, the amount of the counter cation can be easily controlled, and the production cost of the zeolite can be reduced.

### (Counter Cation of Zeolite)

The counter cation of the zeolite according to the first embodiment of the present invention is not particularly limited as long as the effects of the present invention are not impaired. The counter cation of the zeolite is usually a proton, an alkali metal ion, or an alkaline earth metal ion. The counter cation is preferably a proton or an alkali metal ion, and more preferably a proton, a Li ion, a Na ion, or a K ion. In the case of an alkali metal ion or an alkaline earth metal ion, as the size thereof is smaller, the zeolite more easily exhibits an average thermal expansion coefficient of less than 0 ppm/K, which is preferable. Among these, the case where the counter cation of the zeolite is a proton is preferable because the average thermal expansion coefficient of the resin composite material is easily reduced. That is, as the zeolite, a proton type or an alkali metal type is preferable, a proton type, a Li type, a Na type, or a K type is more preferable, and a proton type is particularly preferable.

### (Crystallinity of Zeolite)

The crystallinity of the zeolite according to the first embodiment of the present invention is not particularly limited as long as the effects of the present invention are not impaired. The reason for this is that the Composite Building Unit (CBU) is presumed to be a factor having a greater influence on the average thermal expansion coefficient of the epoxy resin composite material than the structure defined by the code of the IZA. The crystallinity of the zeolite can be obtained by comparing a certain X-ray diffraction peak obtained by an X-ray diffractometer (for example, a table-top X-ray diffractometer D2 PHASER manufactured by BRUKER Corporation) with an X-ray diffraction peak of a reference zeolite. As a specific calculation example, the crystallinity of the LTA type zeolite of Scientific Reports 2016, 6, Article number: 29210 may be mentioned.

### (Surface Treatment of Zeolite)

The zeolite may be subjected to a surface treatment such as a silylation treatment within a range in which the effects of the present invention are not impaired. The surface treatment is not limited to a physical treatment or a chemical treatment.

### (Method for Producing Zeolite)

As a method for producing a zeolite, a known method can be applied. For example, in the case of producing a CHA-type zeolite, it can be produced with reference to the method described in JP 2009-097856 A. In the case of producing a zeolite having a large particle size, hydrothermal synthesis may be performed by appropriately controlling the type and ratio of raw materials, synthesis time, temperature, and the like. Specifically, for example, according to the method described in Microporous and Mesoporous Materials 21 (1998) 24, a zeolite having a large particle size can be produced by increasing the amount of water at the time of synthesis and performing synthesis under a condition in which the concentration of raw materials is diluted.

In addition, the particularly preferable zeolite described above can be produced by the following method (hereinafter, also referred to as a "method for producing a zeolite according to the present invention").

The method for producing a zeolite of the present invention includes a step of hydrothermally synthesizing a raw material composition containing a silicon atom raw material, a water-soluble aluminum atom raw material, an organic structure directing agent, and water, and a step of subsequently firing the raw material composition.

Here, in the raw material composition, the content of alkali metal atoms other than the organic structure directing agent with respect to 1 mol of Si atoms is 0.05 mol or less. If necessary, a desired zeolite (hereinafter, referred to as "seed crystal zeolite" in some cases) may be used.

### «Silicon Atom Raw Material»

The silicon atom raw material used in the present invention is not particularly limited, and various known substances can be used. For example, colloidal silica, amorphous silica, sodium silicate, trimethylethoxysilane, tetraethyl orthosilicate, aluminosilicate gel, and zeolite can be used. Among these, amorphous silica is preferable in that the content of alkali metal is small. These may be used alone, or two or more thereof may be used in any combination at any ratio.

### «Aluminum Atom Raw Material»

As the aluminum atom raw material, a water-soluble raw material is used. In addition, aluminum hydroxide is preferable in that the content of an alkali metal is small, and water-soluble amorphous aluminum hydroxide is particularly preferable in order to grow a zeolite in a spherical shape without aging.

### «Alkali Metal Atom Raw Material»

The alkali metal atom raw material may not be used, but when used, the content of alkali metal atoms other than the organic structure directing agent with respect to 1 mol of Si atoms is 0.05 mol or less. The alkali metal atom in the case of using an alkali metal atom raw material is not particularly limited, and a known alkali metal atom used for synthesis of a zeolite can be used, but at least one alkali metal selected from the group consisting of lithium, sodium, potassium, rubidium, and cesium is preferable. The amount of the alkali metal to be used is preferably 0.045 or less, more preferably 0.04 or less, still more preferably 0.035 or less, and particularly preferably 0.03 or less in terms of a molar ratio to silicon (Si) contained in the raw material composition. It is considered that since the amount of the alkali metal atom raw material is small, the zeolite is likely to grow in a spherical shape, the c-axis length of the crystal lattice is likely to be short, and the average thermal expansion coefficient is likely to be negatively large.

### <<Organic Structure Directing Agent>>

As the organic structure directing agent, various known substances such as tetraethylammonium hydroxide (TEAOH) and tetrapropylammonium hydroxide (TPAOH) can be used. Of these, N,N,N-trimethyl-1-adamantylammonium hydroxide (TMAdaOH) is preferred.

The amount of the organic structure directing agent used is usually 0.01 or more, preferably 0.02 or more, more preferably 0.03 or more, particularly preferably 0.04 or more, and most preferably 0.05 or more in terms of a molar ratio to silicon (Si) contained in the raw material composition. On the other hand, it is usually 1 or less, preferably 0.6 or less, more preferably 0.55 or less, and still more preferably 0.5 or less. Within this range, it is considered that a high-purity spherical zeolite containing few by-products is easily grown.

### «Seed Crystal Zeolite»

In the production method of the present invention, a zeolite as a seed crystal may be used. In the case of using a seed crystal zeolite, one type may be used alone, or two or more types may be used in any combination at any ratio.

### <<Water>>

When a seed crystal zeolite is used, the amount of water used is usually 5 or more, preferably 7 or more, more preferably 9 or more, and still more preferably 10 or more in terms of a molar ratio to silicon (Si) contained in the raw material composition other than the seed crystal zeolite, from the viewpoint that crystals are easily formed. When the amount of water is in this range, crystals are easily formed, which is preferable. In addition, it is considered that a zeolite having a large particle size is easily produced by performing synthesis under a condition in which the concentration of the raw material is diluted by increasing the amount of water. In order to sufficiently obtain the effect of reducing the cost of the waste liquid treatment, the amount of water used is usually 50 or less, preferably 40 or less, more preferably 30 or less, and still more preferably 20 or less in terms of a molar ratio to silicon (Si).

### <<Mixing of Raw Materials (Preparation of Pre-Reaction Raw Material Composition)>>

The raw material composition can be usually obtained by mixing the silicon atom raw material, the aluminum atom raw material, the organic structure directing agent, and water, and then adding the seed crystal zeolite in the case of using the seed crystal zeolite.

In the present invention, in addition to the above-described components, components such as an acid component for accelerating the reaction and a metal stabilizer such as polyamine may be added in an arbitrary step as necessary.

### <<Aging>>

The raw material composition prepared as described above may be subjected to hydrothermal synthesis immediately after the preparation, but in order to obtain a zeolite having higher crystallinity, it is preferable to perform aging for a certain period of time under a predetermined temperature condition. In particular, when the reaction is scaled up, the raw materials are preferably aged while being stirred for a certain period of time because the stirring property is improved and the raw materials can be easily brought into a more uniform state. The aging temperature is usually 100°C or lower, preferably 95°C or lower, more preferably 90°C or lower, and is usually 0°C or higher, preferably 10°C or higher, although the lower limit is not particularly limited. The aging temperature may be constant during the aging, or may be changed stepwise or continuously. The aging time is not particularly limited, but is usually 2 hours or more, preferably 3 hours or more, and more preferably 5 hours or more, and on the other hand, it is usually 30 days or less, preferably 10 days or less, and more preferably 4 days or less.

### «Hydrothermal Synthesis»

Next, the obtained raw material composition is subjected to hydrothermal synthesis.

The hydrothermal synthesis is usually carried out by placing the raw material composition prepared as described above or an aqueous gel obtained by aging the same in a pressure-resistant container, and holding the mixture at a predetermined temperature under self-generated pressure or under gas pressure that does not inhibit crystallinity, under stirring or while rotating or shaking the container, or in a stationary state.

In order to increase the reaction speed, the reaction temperature in the hydrothermal synthesis is usually 120°C or higher, preferably 130°C or higher, more preferably 140°C or higher, and particularly preferably 150°C or higher. On the other hand, it is usually 230°C or lower, preferably 220°C or lower, more preferably 200°C or lower, and still more preferably 190°C or lower. The reaction time is not particularly limited, but is usually 2 hours or more, preferably 3 hours or more, and more preferably 5 hours or more, and on the other hand, it is usually 30 days or less, preferably 10 days or less, more preferably 7 days or less, and still more preferably 5 days or less. The reaction temperature may be constant during the reaction, or may be changed stepwise or continuously.

The reason why a particularly preferable zeolite can be produced by the method for producing a zeolite according to the present invention is presumed as follows. When a zeolite is produced, in general, raw material components are dissolved using an alkali metal. On the other hand, in the method for producing a zeolite according to the present invention, an alkali metal is not used, or even when an alkali metal is used, the amount of the alkali metal is set to a certain amount or less. As a result, in the raw material composition, a crystal is likely to grow from the organic structure directing agent as a starting point, and a crystal is likely to grow spherically from the starting point. Then, it is presumed that strain occurs in a crystal lattice in a process in which the crystal grows spherically, and the strain is fixed by firing. This presumption is also supported by the fact that the c-axis length of the crystal lattice in Examples 1 to 3 (produced by the method for producing a zeolite according to the present invention) to be described later is shorter than that in Comparative Examples 1 (without firing) and 2 (using sodium hydroxide).

In addition, it is presumed that the zeolite according to the first embodiment of the present invention tends to have a low average thermal expansion coefficient due to the presence of the strain generated in the crystal lattice. That is, it is presumed that the zeolite shrinks to eliminate the strain generated in the crystal lattice when the zeolite is heated, and thus the zeolite shrinks. In addition, for the same reason, it is presumed that the zeolite according to the first embodiment of the present invention tends to have a low average thermal expansion coefficient in a high temperature region (in the range of 50 to 350°C). This presumption is also supported by the fact that, in a comparison between Examples 1 to 3 and Comparative Examples 1 and 2 to be described later, the average thermal expansion coefficients of Examples 1 to 3 in which the c-axis length of the crystal lattice is short are lower than those of Comparative Examples 1 and 2.

### [Second Embodiment]

### <Composition>

The composition according to the second embodiment of the present invention is a composition containing the zeolite according to the first embodiment and a resin. As will be described later, the average thermal expansion coefficient of the zeolite according to the first embodiment is likely to be extremely low. Therefore, by containing the zeolite, the thermal expansion of the composite material formed of the composition according to the second embodiment can be suppressed.

The content of the zeolite according to the first embodiment contained in the resin composition is preferably 25% by mass or more, more preferably 30% by mass or more, still more preferably 35% by mass or more, even more preferably 40% by mass or more, particularly preferably 45% by mass or more, and yet still more preferably 50% by mass or more, with respect to the total amount of the composition, from the viewpoint of reducing the thermal expansion coefficient while suppressing an increase in viscosity. On the other hand, the content is preferably 90% by mass or less, more preferably 80% by mass or less, still more preferably 75% by mass or less, and particularly preferably 70% by mass or less.

When the resin composition contains a filler other than the zeolite according to the first embodiment, the content of the zeolite of the present invention in the entire filler is preferably 10% by mass or more, more preferably 30% by mass or more, still more preferably 50% by mass or more, particularly preferably 70% by mass or more, and most preferably 90% by mass or more, because the increase in the viscosity of the kneaded resin is small and the thermal expansion coefficient of the cured product is easily reduced.

### (Resin)

The resin used in the composition according to the second embodiment of the present invention is not particularly limited as long as the effects of the present invention are exhibited, but is preferably at least one selected from the group consisting of an epoxy resin and a polyimide resin from the viewpoint of further exhibiting the effects as a composite material. In particular, when the resin is used as a liquid composition useful as a sealing agent or the like, an epoxy resin is preferred. When the resin is used as a composition useful as a substrate or the like, a polyimide resin is preferred.

The amount of the resin contained in the composition of the present invention is preferably 5% by mass or more, and more preferably 10% by mass or more, based on the total amount of the composition, from the viewpoint of achieving both maintenance of excellent physical properties of the resin and heat resistance (resistance to thermal expansion) as a cured resin composition. On the other hand, the amount of the resin is preferably 50% by mass or less, more preferably 25% by mass or less, and particularly preferably 15% by mass or less.

### «Epoxy Resin»

The epoxy resin used in the present invention will be described in detail in a fifth embodiment of the present invention described later.

### «Polyimide Resin»

The polyimide resin used in the present invention is preferably a polyimide obtained from a tetracarboxylic dianhydride and a diamine, particularly an aromatic polyimide obtained from an aromatic tetracarboxylic dianhydride and an aromatic diamine, because the thermal expansion coefficient of the resin composite material tends to be low, and characteristics such as heat resistance, mechanical strength, electrical characteristics, and solvent resistance are excellent.

More specifically, it is preferable to use a polyimide powder obtained by spraying and granulating a polyimide precursor solution on a polyimide resin powder obtained by polymerizing and imidizing an aromatic tetracarboxylic acid component and p-phenylenediamine, and to composite the polyimide powder with a filler to obtain a resin composite material.

It is to be noted that the polyimide powder is granulated by bonding the polyimide precursor to particles of the polyimide powder, and the polyimide precursor serves as a binder in the aggregate. As the polyimide precursor, for example, a polyamic acid is used, and as a polyimide precursor solution used as a raw material, a polyamic acid produced by reacting a tetracarboxylic dianhydride with a diamine in the presence of a basic compound having a pKa of 7.5 or more using water and/or an alcohol-based solvent as a reaction solvent is used.

Examples of suitable aspects in the second embodiment include a liquid resin composition containing the zeolite according to the first embodiment in which an epoxy resin is used as a resin, the viscosity is 1 Pa ·s or more and 30 Pa ·s or less, and the content of the zeolite is 40 to 70% by mass.

The liquid resin composition is useful as an underfill material (hereinafter, referred to as a "liquid sealing agent" in some cases), can reduce the average thermal expansion coefficient after curing, and is suitable as a sealing agent.

In addition, another suitable aspect in the second embodiment includes a composite material containing the zeolite according to the first embodiment in which an epoxy resin is used as a resin, the content of the zeolite is 40 to 70% by mass, and the average thermal expansion coefficient at 25 to 100°C is 10 to 30 ppm/K.

Since the composite material has a low average thermal expansion coefficient at a temperature of the glass transition temperature or lower, the composite material is useful as various materials, and is particularly effective for electronic devices.

### [Third Embodiment]

### <Composition>

The composition according to the third embodiment of the present invention is a composition containing the zeolite according to the first embodiment described above, a resin, and an inorganic filler having a particle size of 0.1 µm or more and 1.0 µm or less (hereinafter, also referred to as a small particle size inorganic filler).

### (Inorganic Filler)

In the case of a liquid composition, the particle size of the inorganic filler is preferably small from the viewpoint of easy filling of the liquid composition even in a narrow space. On the other hand, the particle size of the inorganic filler is preferably large from the viewpoint of difficulty in increasing the viscosity of the liquid composition. In the case where a filler having a small specific surface area and a filler having a large specific surface area are used in combination, the interaction between the filler and the resin increases as the specific surface area increases, and thus the viscosity of the liquid composition is likely to increase. For this reason, in order to reduce the viscosity of the liquid composition, the specific surface area of the filler is preferably small. The specific surface area tends to be larger as the particle size is smaller. In addition, the specific surface area also varies depending on the shape of the filler, and a spherical filler has the smallest specific surface area. Therefore, from the viewpoint of reducing the viscosity, it is preferable that the inorganic filler has a shape close to a spherical shape and has a large particle size. Therefore, in particular, the specific surface area of the large particle size zeolite is preferably 1 × 10⁻⁶ (/m) or less, and more preferably 0.8 × 10⁻⁶ (/m) or less.

In the present invention, by using a filler having a small particle size and a filler having a large particle size in combination, the small particles enter the gaps between the large particles, the filling amount can be increased, the thermal expansion coefficient can be reduced, and an increase in viscosity can be reduced. Therefore, the composition of the present invention preferably contains a large particle size zeolite and a small particle size inorganic filler from the viewpoint that the thermal expansion coefficient is likely to be low.

The particle size of the inorganic filler is measured in the same manner as that of the zeolite according to the first embodiment described above. That is, the particle size of the inorganic filler means a diameter (circle equivalent diameter) of a circle having an area equal to a projected area of the particle and having a maximum diameter in observation of the particle with a scanning electron microscope (SEM). In addition, the particle size is the particle size of the primary particle.

Examples of the inorganic filler used in the composition of the present invention include a zeolite and inorganic fillers other than a zeolite.

A zeolite is an inorganic filler having a low thermal expansion coefficient, and can reduce the thermal expansion coefficient of the epoxy resin composite material which is a cured product of the liquid composition according to one preferred aspect of the present invention. However, zeolite has a porous structure and thus has a large specific surface area, and when a large amount of zeolite is blended, the viscosity of the liquid composition is likely to increase. In the present invention, as a result of various studies, it has been found that, for example, while the thermal expansion coefficient of the liquid epoxy resin composite material is reduced, an increase in the viscosity is prevented, and a lowering in the viscosity of the liquid composition can be realized by containing a small particle size inorganic filler to the liquid composition in addition to the large particle size zeolite such as the zeolite according to the first embodiment described above.

Examples of the inorganic filler other than the zeolite include at least one selected from the group consisting of metal, carbon, metal carbide, metal oxide, and metal nitride. Examples of the metal include silver, copper, aluminum, gold, nickel, iron, and titanium. Examples of the carbon include carbon black, carbon fiber, graphite, fullerene, and diamond. Examples of the metal carbide include silicon carbide, titanium carbide, and tungsten carbide. Examples of the metal oxide include silicon oxide such as magnesium oxide, aluminum oxide (alumina), and silica, calcium oxide, zinc oxide, yttrium oxide, zirconium oxide, cerium oxide, ytterbium oxide, and sialon (a ceramic composed of silicon, aluminum, oxygen, and nitrogen). Examples of the metal nitride include boron nitride, aluminum nitride, and silicon nitride.

### (Content of Large Particle Size Zeolite)

In the composition according to the third embodiment of the present invention, when the resin composition is a liquid composition, the content of the zeolite of the first embodiment in the composition is preferably 20% by mass or more, more preferably 25% by mass or more, still more preferably 30% by mass or more, particularly preferably 40% by mass or more, and most preferably 45% by mass or more, with respect to the total amount of the liquid composition, from the viewpoint of reducing the thermal expansion coefficient while suppressing an increase in viscosity. On the other hand, the content is preferably 90% by mass or less, more preferably 80% by mass or less, still more preferably 75% by mass or less, and particularly preferably 70% by mass or less.

In addition, the content of the zeolite (large particle size zeolite) in the entire filler is preferably 10% by mass or more, more preferably 30% by mass or more, still more preferably 50% by mass or more, particularly preferably 70% by mass or more, and most preferably 90% by mass or more because an increase in viscosity at the time of resin kneading is small and the thermal expansion coefficient of the cured product is easily reduced.

### (Small Particle Size Inorganic Filler)

The small particle size inorganic filler may be a zeolite or may be an inorganic filler other than a zeolite. Specific examples of the inorganic filler other than zeolite are as described above.

From the viewpoint of lowering the thermal expansion coefficient, the small particle size inorganic filler is preferably a zeolite, a metal nitride, a metal oxide, or the like.

The content of the small particle size inorganic filler is preferably large from the viewpoint that the effect of using the filler is easily sufficiently exhibited. On the other hand, in the case of a liquid composition, the content is preferably small from the viewpoint that the fluidity of the liquid composition is increased and the liquid composition can be easily filled in a narrow space. In particular, since the small particle size inorganic filler has a large specific surface area and easily increases the viscosity, it is easy to increase the fluidity by reducing the use amount.

In the composition according to the third embodiment of the present invention, specifically, the content of the small particle size inorganic filler is preferably 1% by mass or more, more preferably 5% by mass or more, and particularly preferably 10% by mass or more, with respect to the total amount of the composition. On the other hand, the content is preferably 50% by mass or less, more preferably 45% by mass or less, and still more preferably 40% by mass or less.

### (Shape of Small Particle Size Inorganic Filler)

The shape of the small particle size inorganic filler is not particularly limited as long as the composition and the resin composite material exhibit preferable performance, and may be a spherical shape, a whisker shape, a fibrous shape, a plate shape, or an aggregate thereof. However, a spherical shape is preferable because the small particle size inorganic filler is contained while suppressing an increase in viscosity.

The sphericity of the small particle size inorganic filler is preferably 0.6 or more, more preferably 0.65 or more, and particularly preferably 0.70 or more. The upper limit of the sphericity is not particularly limited, and may be 1 or less.

Therefore, in the third embodiment of the present invention, the sphericity of each of the large particle size zeolite and the small particle size inorganic filler is preferably 0.6 or more, more preferably 0.65 or more, and particularly preferably 0.70 or more. In addition, it is preferable that the sphericity of the small particle size inorganic filler is higher than that of the large particle size zeolite.

The roundness of the small particle size inorganic filler is preferably 0.786 or more, more preferably 0.790 or more, still more preferably 0.795 or more, even more preferably 0.800 or more, yet still more preferably 0.805 or more, particularly preferably 0.810 or more, yet even more preferably 0.815 or more, and most preferably 0.820 or more. The upper limit of the roundness is not particularly limited, and may be 1 or less. The methods for measuring the sphericity and the roundness are as described above.

### (Amount of Total Inorganic Filler)

The total content of all the inorganic fillers (total inorganic filler) contained in the composition is preferably large from the viewpoint of easily exhibiting the effect as a filler. On the other hand, the total content of all the inorganic fillers is preferably small from the viewpoint of high fluidity in the case of a liquid composition and easy filling even in a narrow space. Specifically, in the composition according to the third embodiment of the present invention, the total content of the total inorganic filler is preferably 30% by mass or more, more preferably 35% by mass or more, and particularly preferably 40% by mass or more, with respect to the total amount of the composition. On the other hand, the total content of all the inorganic fillers is preferably 95% by mass or less, more preferably 90% by mass or less, and particularly preferably 85% by mass or less.

### [Fourth Embodiment]

### <Composition>

The composition according to the fourth embodiment of the present invention contains a resin, a zeolite, and a dispersant having at least one functional group of an amino group and an amine salt. Here, the zeolite is preferably the zeolite (large particle size zeolite) according to the first embodiment described above.

The present inventors have found that when a composition containing an epoxy resin and a zeolite filler is in a liquid state, a dispersant containing at least an amino group or an amine salt is excellent from the viewpoint of reducing the viscosity. Therefore, the composition of the present invention preferably contains a dispersant containing at least an amino group or an amine salt from the viewpoint that the viscosity is likely to be low. That is, as the dispersant used in the fourth embodiment of the present invention, a dispersant having at least one functional group of an amino group and an amine salt is used. In addition, the dispersant preferably has an amino group at a terminal from the viewpoint of reducing the viscosity in a case where the composition is in a liquid state. The amine salt may be modified with an acid group such as phosphoric acid. In the fourth embodiment of the present invention, by using the specific dispersant, it is possible to prevent an increase in the viscosity of the liquid composition while using the zeolite as the inorganic filler.

### (Dispersant)

The composition according to the fourth embodiment of the present invention contains a dispersant in order to enhance the dispersibility of the inorganic filler such as a zeolite. The dispersant used in the composition containing a resin and a filler is mainly added to a liquid composition containing a resin and a filler having a large difference in polarity, thereby improving the interface state between the two and improving the compatibility. As a result, effects such as a lowering in viscosity, improvement in dispersibility of the filler, and prevention of aggregation and sedimentation of the filler can be exhibited.

Examples of the dispersant in the fourth embodiment include an acrylic dispersant and a polymer dispersant. Here, the "polymer dispersant" means a dispersant having a weight average molecular weight of 1,000 or more. In addition, the main chain skeleton of the polymer dispersant is not particularly limited, and examples thereof include a polyurethane skeleton, a polyacrylic skeleton, a polyester skeleton, a polyamide skeleton, a polyimide skeleton, and a polyurea skeleton, and from the viewpoint of storage stability, a polyurethane skeleton, a polyacrylic skeleton, and a polyester skeleton are preferable. The structure of the polymer dispersant is also not particularly limited, and examples thereof include a random structure, a block structure, a comb structure, and a star structure. Similarly, from the viewpoint of storage stability, a block structure or a comb structure is preferable.

The polymer dispersant has a structure having a polar group at a terminal or in an intramolecular structure, and it is known that the effect thereof varies depending on the surface polarity of the inorganic filler. Examples of the polar group at the terminal include a carboxy group, an amino group, a phosphoric acid group, and a hydroxy group, and examples of the intramolecular structure include an ester and a fatty acid amide.

The dispersant is preferably a solventless type dispersant containing no solvent, particularly preferably a solventless type polymer dispersant. When the dispersant contains no solvent, it is possible to prevent voids from being generated due to volatilization of the dispersant when the composition is heated and cured.

In the present embodiment, the dispersant is preferably a dispersant having at least an amino group or an amine salt, from the viewpoint of reducing the viscosity. The details of the dispersant having at least an amino group or an amine salt are as described in the sixth embodiment described later.

As the dispersant, a commercially available product can also be used. Examples of commercially available products of the polymer dispersant include a wet dispersant DISPERBYK series 101, 102, 103, 106, 108, 109, 110, 111, 112, 116, 130, 140, 142, 145, 161, 162, 163, 164, 166, 167, 168, 170, 171, 174, 108, 182, 183, 184, 185, 2000, 2001, 2008, 2020, 2050, 2070, 2096, 2150, 2152, 2155 commercially available from BYK-Chemie Co., Ltd.; EFKA series 4008, 4009, 4010, 4015, 4020, 4046, 4047, 4050, 4055, 4060, 4080, 4300, 4330, 4340, 4400, 4401, 4402, 4403, 4406, 4800, 5010, 5044, 5054, 5055, 5063, 5064, 5065, 5066, 5070, 5244 commercially available from BASF Japan Ltd.; Solsperse series 3000, 5000, 11200, 13240, 13650, 13940, 16000, 17000, 18000, 20000, 21000, 24000SC, 24000GR, 26000, 28000, 31845, 32000, 32500, 32550, 32600, 33000, 34750, 35100, 35200, 36000, 36600, 37500, 38500, 39000, 53095, 54000, 55000, 56000, 71000 commercially available from Lubrizol Corporation; DISPARLON series 1210, 1220, 1831, 1850, 1860, 2100, 2150, 2200, 7004, KS-260, KS-273N, KS-860, KS-873N, PW-36, DN-900, DA-234, DA-325, DA-375, DA-550, DA-1200, DA-1401, DA-7301 commercially available from Kusumoto Chemicals, Ltd.; AJISPER series PB-711, PB-821, PB-822, PN-411, PA-111 commercially available from Ajinomoto Co., Inc.; SURFYNOL series 104A, 104C, 104E, 104H, 104S, 104BC, 104DPM, 104PA, 104PG-50, 420, 440, DF110D, DF110L, DF37, DF58, DF75, DF210, CT111, CT121, CT131, CT136, GA, TG, TGE commercially available from Air Products and Chemicals, Inc.; OLFINE series STG and E1004 commercially available from Nissin Chemical Industries, Ltd.; SN-Sperse series 70, 2120, and 2190 manufactured by San Nopco Limited; ADEKA COL and ADEKA TOL series commercially available from ADEKA Corporation; and SANNONIC series, NAROACTY CL series, EMULMIN series, NEWPOL PE series, IONET M series, IONET D series, IONET S series, IONET T series, SANSEPARER 100 commercially available from Sanyo Chemical Industries, Ltd.

In the fourth embodiment, the content of the dispersant is preferably large from the viewpoint of, for example, easily uniformly dispersing the inorganic filler in a case where the composition is liquid. On the other hand, the content of the dispersant is preferably small from the viewpoint that an increase in the thermal expansion coefficient due to phase separation of the inorganic filler and the resin such as an epoxy resin is unlikely to occur. The content of the dispersant is preferably 0.1% by mass or more and 30% by mass or less and more preferably 0.1% by mass or more and 25% by mass or less with respect to the total amount of the composition because it is easy to fill a narrow space with the liquid composition and to obtain a low thermal expansion coefficient after curing.

In each of the above-described embodiments, when the composition is a liquid composition, the viscosity of the liquid composition is preferably low from the viewpoint of easily filling the composition even in a narrow space. On the other hand, the viscosity of the liquid composition is preferably high from the viewpoint that dripping or the like hardly occurs at the time of filling the composition. The viscosity of the liquid composition at 23°C is preferably 0.1 Pa ·s or more, more preferably 1 Pa ·s or more, still more preferably 5 Pa ·s or more, and particularly preferably 10 Pa ·s or more. On the other hand, the viscosity of the liquid composition at 23°C is preferably 250 Pa ·s or less, more preferably 200 Pa ·s or less, still more preferably 150 Pa ·s or less, and particularly preferably 30 Pa ·s or less.

As a suitable aspect of the composition, a liquid composition in which an epoxy resin is used as the resin and the zeolite of the first embodiment is used as the zeolite is preferable. Here, the viscosity is preferably 1 Pa ·s or more and 30 Pa ·s or less. The content of the zeolite is preferably 40 to 70% by mass.

The liquid composition is useful as an underfill material and can reduce the average thermal expansion coefficient after curing, and therefore is suitable as a sealing agent.

When the composition in each of the second to fourth embodiments described above is a liquid, a resin composite material can be obtained by curing the composition. For example, when the resin is an epoxy resin, the resin composite material is an epoxy resin composite material. Details of the epoxy resin composite material are as described below. When the resin is a polyimide resin, the resin composite material is a polyimide resin composite material.

The average thermal expansion coefficient of the resin composite material at 25 to 100°C is preferably 0 ppm/K or more, more preferably 2 ppm/K or more, still more preferably 4 ppm/K or more, and particularly preferably 10 ppm/K or more. On the other hand, the average thermal expansion coefficient of the resin composite material at 25 to 100°C is preferably 200 ppm/K or less, more preferably 100 ppm/K or less, and particularly preferably 30 ppm/K or less.

In particular, in the composition of the second embodiment, when an epoxy resin is used as the resin and the zeolite of the first embodiment is used as the zeolite, the content of the zeolite is preferably 40 to 70% by mass, and the average thermal expansion coefficient at 25 to 100°C is preferably 10 to 30 ppm/K.

Such a resin composite material has a low average thermal expansion coefficient at a temperature of the glass transition temperature or lower, and thus is useful as a material for which various heat resistances are required, and is particularly effective for application to electronic devices.

### <Resin Composite Material>

In one aspect of the present invention, the resin composite material can be obtained by curing the above-described composition (the composition of the second to fourth embodiments). For example, in the case where the resin is an epoxy resin, an epoxy resin composite material can be obtained. In the case where the resin is an epoxy resin, the composition is preferably a liquid composition. The epoxy resin composition and the method for producing an epoxy resin composite material will be described in detail in the fifth embodiment of the invention described later.

In addition, in a case where the resin is a polyimide resin, a polyimide resin composite material can be obtained. As a method for producing a polyimide resin composite material, for example, the method described below may be performed.

### (Method for Producing Polyimide Resin Composite Material)

For molding the polyimide resin composite material, various known press apparatuses for molding a thermoplastic resin can be used. The temperature for heating at the time of molding is affect by the properties of the resins used and is not particularly limited, but is usually 250°C or higher, preferably 300°C or higher, more preferably 350°C or higher, and still more preferably 390°C or higher. In addition, from the viewpoint that deterioration of the resin during hot pressing hardly occurs, it is preferable to use a vacuum press apparatus capable of reducing the amount of oxygen in the press machine during heating or a press machine provided with a nitrogen substitution apparatus.

### [Fifth Embodiment]

### <Liquid Composition>

The liquid composition according to the fifth embodiment of the present invention contains an epoxy resin and an inorganic filler.

### (Inorganic Filler)

In the liquid composition according to the fifth embodiment, a zeolite and an inorganic filler other than a zeolite are used as the inorganic filler. The inorganic filler other than zeolite is preferably the same filler as the inorganic filler used in the third embodiment, and the preferred range and the like are also preferably the above-described range and the like.

The inorganic filler contained in the liquid composition according to the fifth embodiment of the present invention contains a zeolite having a particle size of 1.0 µm or more and 10 µm or less (large particle size zeolite) and an inorganic filler having a particle size of 0.1 µm or more and less than 1.0 µm (small particle size inorganic filler).

The zeolite is an inorganic filler having a low thermal expansion coefficient, and can reduce the thermal expansion coefficient of the epoxy resin composite material which is a cured product of the liquid composition, but has a large specific surface area, and when a large amount of zeolite is blended, the viscosity of the liquid composition is likely to increase. In the present invention, as a result of various studies, by including a small particle size inorganic filler in a liquid composition in addition to a large particle size zeolite, it is possible to prevent an increase in viscosity while lowering the thermal expansion coefficient of the epoxy resin composite material, and to realize a low viscosity of the liquid composition.

The particle size of the inorganic filler is preferably small from the viewpoint of easily filling the liquid composition even in a narrow space. On the other hand, the particle size of the inorganic filler is preferably large from the viewpoint of difficulty in increasing the viscosity of the liquid composition. In the case where a filler having a small specific surface area and a filler having a large specific surface area are used in combination, the interaction between the filler and the resin increases as the specific surface area is larger, and thus the viscosity of the liquid composition is likely to increase. For this reason, in order to reduce the viscosity of the liquid composition, the specific surface area of the filler is preferably small. The specific surface area tends to be larger as the particle size is smaller. In addition, the specific surface area also varies depending on the shape of the filler, and a spherical filler has the smallest specific surface area. Therefore, from the viewpoint of reducing the viscosity, it is preferable that the inorganic filler has a shape close to a spherical shape and has a large particle size. Therefore, in particular, the specific surface area of the large particle size zeolite is preferably 1 × 10⁻⁶ (/m) or less, and more preferably 0.8 × 10⁻⁶ (/m) or less.

In the present invention, by using a filler having a small particle size and a filler having a large particle size in combination, the small particles enter the gaps between the large particles, the filling amount can be increased, the thermal expansion coefficient can be reduced, and an increase in viscosity can be reduced.

The particle size of the inorganic filler such as a zeolite is a particle size of each particle, and means a diameter (circle equivalent diameter) of a circle having an area equal to a projected area of the particle and having a maximum diameter in observation of the particle with a scanning electron microscope (SEM). In addition, the particle size is the particle size of the primary particle.

### (Content of Large Particle Size Zeolite)

In the liquid composition according to the fifth embodiment of the present invention, the content of the large particle size zeolite is preferably large from the viewpoint that the effect of reducing the average thermal expansion coefficient is easily exhibited. On the other hand, the content of the large particle size zeolite is preferably small from the viewpoint that the fluidity of the liquid composition is increased and it is easy to fill a narrow space with the liquid composition. Specifically, the content of the large particle size zeolite is preferably 20% by mass or more, more preferably 25% by mass or more, and particularly preferably 30% by mass or more, with respect to the total amount of the liquid composition. On the other hand, the content of the large particle size zeolite is preferably 80% by mass or less, more preferably 75% by mass or less, and particularly preferably 70% by mass or less.

### (Small Particle Size Inorganic Filler)

The small particle size inorganic filler may be a zeolite or may be an inorganic filler other than a zeolite. Specific examples and the like of the inorganic filler other than a zeolite are as described above.

From the viewpoint of lowering the thermal expansion coefficient, the small particle size inorganic filler is preferably a zeolite, a metal nitride, a metal oxide, or the like.

The content of the small particle size inorganic filler is preferably large from the viewpoint that the effect of using the filler is easily sufficiently exhibited. On the other hand, the content of the small particle size zeolite is preferably small from the viewpoint that the fluidity of the liquid composition is increased and it is easy to fill a narrow space with the liquid composition. In particular, since the small particle size inorganic filler has a large specific surface area and easily increases the viscosity, it is easy to increase the fluidity by reducing the use amount.

In the liquid composition according to the fifth embodiment of the present invention, specifically, the content of the small particle size inorganic filler is preferably 1% by mass or more, more preferably 5% by mass or more, and particularly preferably 10% by mass or more, with respect to the total amount of the liquid composition. On the other hand, the content is preferably 50% by mass or less, more preferably 45% by mass or less, and still more preferably 40% by mass or less.

### (Zeolite)

Hereinafter, the zeolite used in the present invention will be described in more detail. In the following description, the large particle size zeolite will be described unless otherwise noted, but even in a case where the zeolite is used as a zeolite as an inorganic filler other than the large particle size zeolite, it is preferable that the zeolite has the characteristics described below other than the particle size. For example, when the zeolite is used as the small particle size inorganic filler, it is preferable that the zeolite used as the small particle size inorganic filler also has the characteristics described below. The same applies to the zeolite in the sixth and seventh embodiments described later.

As the large particle size zeolite, the zeolite according to the first embodiment described above is preferable.

### (Structure of Zeolite)

A zeolite is a compound containing silicon or aluminum and oxygen and having a TO₄ unit (T element is an element other than oxygen constituting the skeleton) as a basic unit. Specific examples of the zeolite include a crystalline porous aluminosilicate, a crystalline porous aluminophosphate (ALPO), and a crystalline porous silicoaluminophosphate (SAPO).

A zeolite is composed of a structural unit called Composite Building Unit (hereinafter, may be referred to as "CBU") in which several (several to several tens) TO₄ units are connected. Therefore, it has regular channels (tubular pores) and cavities.

The CBU and the crystal structure of the zeolite to be described later can be represented by a code that defines the structure of the zeolite defined by the International Zeolite Association (IZA). The structure of the zeolite can be identified by using a Zeolite Structure Database, 2018 edition (http://www.iza-structure.org/databases/) on the basis of an X-ray diffraction pattern obtained by an X-ray structure analyzer (for example, a table-top X-ray diffractometer "D2 PHASER" manufactured by BRUKER Corporation).

### (Composition of Zeolite)

The zeolite of the present invention is not particularly limited as long as the effects of the present invention are not impaired, but an aluminosilicate containing at least an aluminum atom and a silicon atom in the framework structure is preferable because it is advantageous for application to a filler. As the zeolite, one type may be used alone, or two or more types may be used in any combination and in any ratio.

### (Framework of Zeolite)

The framework of the zeolite is not particularly limited as long as the liquid composition and the epoxy resin composite material obtained by curing the liquid composition described later exhibit preferable performance. Since it is easy to obtain an epoxy resin composite material having a low thermal expansion coefficient by curing the liquid composition, the framework of the zeolite preferably has at least one structure of d6r and mtw as CBU, and more preferably has d6r. Specifically, the liquid composition and the epoxy resin composite material preferably contain 1% by mass or more of the zeolite having the above-described preferred structure as (CBU) and an epoxy resin.

Examples of the zeolite having d6r as CBU include zeolites having AEI, AFT, AFV, AFX, AVL, CHA, EAB, EMT, ERI, FAU, GME, JSR, KFI, LEV, LTL, LTN, MOZ, MSO, MWW, OFF, SAS, SAT, SAV, SBS, SBT, SFW, SSF, SZR, TSC, or -WEN type structure.

Examples of the zeolite having mtw as CBU include zeolites having *BEA, BEC, CSV, GON, ISV, ITG, *-ITN, IWS, MSE, MTW, SFH, SFN, SSF, *-SSO, UOS, or UOV type structure.

In order to three dimensionally interact with a part of the epoxy group contained in the epoxy resin, it is more preferable that the zeolite further has a three dimensional channel. Examples thereof include zeolites having AEI, AFT, AFX, *BEA, BEC, CHA, EMT, ERI, FAU, GME, ISV, ITG, *-ITN, IWS, JSR, KFI, MOZ, MSE, OFF, SAT, SAV, SBS, SBT, SFW, SZR, TSC, UOS, UOV, or -WEN type structure.

Among these, a zeolite having a structure of an 8-membered oxygen ring or less is particularly preferable from the viewpoint of easily controlling the particle size. Examples of the zeolite having a structure of an 8-membered oxygen ring or less include zeolites having AEI, AFT, AFX, CHA, ERI, KFI, SAT, SAV, SFW, or TSC type structure. Among these, zeolites having AEI, AFX, CHA, or ERI type structure are more preferable, and a zeolite having a CHA structure is most preferable because the structure is stable even when the shape is controlled. In the description herein, the structure having an 8-membered oxygen ring means a structure in which the number of oxygen elements is 8 in the case where the number of oxygen is the largest in the pores composed of oxygen forming the zeolite framework and the T element (element other than oxygen constituting the framework).

### (Average Thermal Expansion Coefficient of Zeolite)

The average thermal expansion coefficient of the zeolite is not particularly limited as long as the liquid composition and the epoxy resin composite material obtained by curing the liquid composition exhibit preferable performance. The average thermal expansion coefficient of the zeolite is preferably low from the viewpoint that the average thermal expansion coefficients of the liquid composition and the epoxy resin composite material are easily reduced with a small amount of the zeolite. In addition, as the amount of the filler is smaller, an increase in the viscosity of the liquid composition due to the addition of the filler can be suppressed, and thus the amount of the filler is preferably small. Therefore, the average thermal expansion coefficient of the zeolite is usually less than 0 ppm/K, preferably -2 ppm/K or less, more preferably -3 ppm/K or less, still more preferably -5 ppm/K or less, particularly preferably -6 ppm/K or less, and most preferably -8 ppm/K or less.

On the other hand, the average thermal expansion coefficient of the zeolite is preferably high from the viewpoint that the difference between the average thermal expansion coefficient of the zeolite and the average thermal expansion coefficient of the resin is small and the zeolite and the resin are hardly peeled off. Therefore, the average thermal expansion coefficient of the zeolite is usually -1000 ppm/K or more, preferably -900 ppm/K or more, more preferably -800 ppm/K or more, still more preferably -700 ppm/K or more, particularly preferably -500 ppm/K or more, and most preferably -300 ppm/K or more.

That is, when the average thermal expansion coefficient of the zeolite is within the above range, an increase in the viscosity of the liquid composition can be suppressed, the liquid composition can be easily filled into a gap between various constituent members, and the average thermal expansion coefficient of the cured epoxy resin composite material can be reduced. The average thermal expansion coefficient of zeolite can be measured by calculating lattice constants using an X-ray diffractometer "D8 ADVANCE" manufactured by BRUKER Corporation and X-ray diffraction analysis software "JADE".

### (Shape of Zeolite)

The shape of the zeolite is not particularly limited as long as the liquid composition and the epoxy resin composite material exhibit preferable performance, and may be a spherical shape, a whisker shape, a fibrous shape, a plate shape, or an aggregate thereof. However, a spherical shape is preferable because it is easy to contain the zeolite while suppressing an increase in viscosity.

The sphericity of the zeolite is preferably 0.6 or more, more preferably 0.65 or more, and particularly preferably 0.70 or more. The upper limit of the sphericity is not particularly limited, and may be 1 or less.

In the description herein, "sphericity" is defined as "the ratio of the minimum diameter to the maximum diameter of a particle". Fifty zeolites contained in the liquid composition or the epoxy resin composite material are randomly selected, the sphericity thereof is measured, and the average value thereof is used. Each of the maximum diameter and the minimum diameter can be determined by observation with a scanning electron microscope (SEM). In the first embodiment, as described above, the sphericity of the large particle size zeolite is preferably in the above-described range.

### (Framework Density of Zeolite)

The framework density of the zeolite is not particularly limited as long as the effects of the present invention are not impaired. The framework density of the zeolite is preferably low from the viewpoint that structural vibration of the zeolite is likely to occur and the average thermal expansion coefficient is likely to be low. Therefore, the framework density of the zeolite is preferably 17.0 T/1000 Å³ or less, and more preferably 16.0 T/1000 Å³ or less.

On the other hand, the framework density of the zeolite is preferably high from the viewpoint that the structural stability of the zeolite is likely to be high. Therefore, the framework density of the zeolite is preferably 12.0 T/1000 Å³ or more, more preferably 13.0 T/1000 Å³ or more, and still more preferably 14.0 T/1000 Å³ or more. When the framework density is within the above range, the zeolite can be used as a stable filler.

The framework density indicates the number of T atoms present per unit volume of the zeolite, and is a value determined by the structure of the zeolite. In the description herein, numerical values described in IZA Zeolite Structure Database, 2017 edition (http://www.iza-structure.org/databases/) may be used.

Examples of the zeolite having a framework density of more than 16.0 T/1000 Å³ and 17.0 T/1000 Å³ or less include zeolites having CSV, ERI, ITG, LTL, LTN, MOZ, MSE, OFF, SAT, SFH, SFN, SSF, *-SSO, and -WEN type structures.

Examples of the zeolite having a framework density of more than 15.0 T/1000 Å³ and 16.0 T/1000 Å³ or less include zeolites having AEI, AFT, AFV, AFX, AVL, *BEA, BEC, EAB, GME, *-ITN, LEV, MWW, or SFW type structure.

Examples of the zeolite having a framework density of more than 14.0 T/1000 Å³ and 15.0 T/1000 Å³ or less include zeolites having CHA, ISV, IWS, KFI, SAS, or SAV type structure.

Examples of the zeolite in which the framework density is in the range of 14.0 T/1000 Å³ or less include zeolites having EMT, FAU, JSR, SBS, SBT, or TSC type structure.

### (Silica/Alumina Molar Ratio (SAR) of Zeolite)

The silica/alumina molar ratio (which may be referred to as "SAR", "Si/Al₂ molar ratio", or "Si/Al₂ ratio") of the zeolite is not particularly limited as long as the effects of the present invention are not impaired. The SAR (Si/Al₂ ratio) of the zeolite is preferably high from the viewpoint that the moisture resistance of the epoxy resin composite material becomes high and the amount of the counter cation is easily controlled. Therefore, the SAR (Si/Al₂ ratio) of the zeolite is usually 2 or more, preferably 3 or more, more preferably 3.5 or more, still more preferably 4 or more, particularly preferably 4.5 or more, and most preferably 5 or more.

On the other hand, the SAR (Si/Al₂ ratio) of the zeolite is preferably low from the viewpoint of being easily produced at low cost. Therefore, the SAR (Si/Al₂ ratio) of the zeolite is usually 2000 or less, preferably 1000 or less, still more preferably 500 or less, and even more preferably 100 or less. When the Si/Al₂ ratio is within the above range, the amount of the counter cation can be easily controlled, and the production cost of the zeolite can be reduced.

When an element such as gallium, iron, boron, titanium, zirconium, tin, zinc, or phosphorus is used instead of silicon or aluminum, the molar ratio of the oxide of the substituted element may be converted as the molar ratio of alumina or silica. Specifically, when gallium is used instead of aluminum, the molar ratio of gallium oxide may be converted as the molar ratio of alumina.

The Si/Al₂ ratio of the zeolite can be adjusted by the kinds and ratios of the silicon-containing compound and the aluminum-containing compound as raw materials, the kind and amount of the structure directing agent, the use of a seed crystal, synthesis conditions such as temperature and time, and the like.

### (Counter Cation of Zeolite)

The counter cation of the zeolite is not particularly limited as long as the effects of the present invention are not impaired. The counter cation of the zeolite is usually a structure directing agent, a proton, an alkali metal ion, or an alkaline earth metal ion, preferably a structure directing agent, a proton, or an alkali metal ion, and more preferably a structure directing agent, a proton, a Li ion, a Na ion, or a K ion. In the case where the counter cation of the zeolite is the structure directing agent, since the zeolite has flexibility as compared with the alkali metal ion or the alkaline earth metal ion, the zeolite is more likely to exhibit an average thermal expansion coefficient of less than 0 ppm/K, which is preferable. Further, in the alkali metal ion or the alkaline earth metal ion, as the size thereof is smaller, the zeolite more easily exhibits an average thermal expansion coefficient of less than 0 ppm/K, which is preferable. Among these, the case where the counter cation of the zeolite is a proton is preferable because the average thermal expansion coefficient of the resin composite material is easily reduced. That is, the zeolite is preferably an as-made (structure directing agent-containing type), a proton type, or an alkali metal type, and more preferably an as-made, a proton type, a Li type, a Na type, or a K type. The structure directing agent is a template used in the production of the zeolite.

### (Crystallinity of Zeolite)

The crystallinity of the zeolite is not particularly limited as long as the effects of the present invention are not impaired. The reason for this is that the Composite Building Unit (CBU) is presumed to be a factor having a greater influence on the average thermal expansion coefficient of the epoxy resin composite material than the structure defined by the code of the IZA. The crystallinity of the zeolite can be obtained by comparing a certain X-ray diffraction peak obtained by an X-ray diffractometer (for example, a table-top X-ray diffractometer "D2 PHASER" manufactured by BRUKER Corporation) with an X-ray diffraction peak of a reference zeolite. As a specific calculation example, the crystallinity of the LTA type zeolite of Scientific Reports 2016, 6, Article number: 29210 may be mentioned.

### (Surface Treatment of Zeolite)

The zeolite may be subjected to a surface treatment such as a silylation treatment within a range in which the effects of the present invention are not impaired. The surface treatment is not limited to a physical treatment or a chemical treatment.

### (Method for Producing Zeolite)

As a method for producing a zeolite, a known method can be applied. For example, in the case of producing a CHA-type zeolite, it can be produced with reference to the method described in JP 2009-097856 A. In the case of producing a zeolite having a large particle size, hydrothermal synthesis may be performed by appropriately controlling the type and ratio of raw materials, synthesis time, temperature, and the like. Specifically, for example, according to the method described in Microporous and Mesoporous Materials 21 (1998) 24, a zeolite having a large particle size can be produced by increasing the amount of water at the time of synthesis and performing synthesis under a condition in which the concentration of raw materials is diluted.

### (Shape of Small Particle Size Inorganic Filler)

The shape of the small particle size inorganic filler is not particularly limited as long as the liquid composition and the resin composite material exhibit preferable performance, and may be a spherical shape, a whisker shape, a fibrous shape, a plate shape, or an aggregate thereof. However, a spherical shape is preferable because the small particle size inorganic filler is contained while suppressing an increase in viscosity.

The sphericity of the small particle size inorganic filler is preferably 0.6 or more, more preferably 0.65 or more, and particularly preferably 0.70 or more. The upper limit of the sphericity is not particularly limited, and may be 1 or less.

Therefore, in the fifth embodiment of the present invention, the sphericity of each of the large particle size zeolite and the small particle size inorganic filler is preferably 0.6 or more, more preferably 0.65 or more, and particularly preferably 0.70 or more.

In addition, it is preferable that the sphericity of the small particle size inorganic filler is higher than that of the large particle size zeolite.

### (Amount of Total Inorganic Filler)

The total content of all the inorganic fillers (total inorganic filler) contained in the liquid composition is preferably large from the viewpoint of easily exhibiting the effect as a filler. On the other hand, the total content of the total inorganic filler is preferably small from the viewpoint that the fluidity of the liquid composition is increased and it is easy to fill a narrow space with the liquid composition. Specifically, in the liquid composition according to the fifth embodiment of the present invention, the total content of the total inorganic filler is preferably 30% by mass or more, more preferably 35% by mass or more, and particularly preferably 40% by mass or more, with respect to the total amount of the composition. On the other hand, it is preferably 95% by mass or less, more preferably 90% by mass or less, and particularly preferably 85% by mass or less.

### (Epoxy Resin)

As the epoxy resin used in the present invention, an epoxy compound having an aromatic ring such as a bisphenol A type skeleton, a bisphenol F type skeleton, or a biphenyl skeleton is preferably used because the thermal expansion coefficient of the epoxy resin composite material obtained by curing the liquid composition is likely to be low. Specific examples of the epoxy resin include a bisphenol A type epoxy resin, a bisphenol F type epoxy resin, a bisphenol S type epoxy resin, a biphenyl type epoxy resin, a naphthalene ring-containing epoxy resin, an epoxy resin having a dicyclopentadiene skeleton, a phenol novolac type epoxy resin, a cresol novolac type epoxy resin, a triphenylmethane type epoxy resin, an aminophenol type epoxy resin, an aliphatic epoxy resin, and a copolymer epoxy resin of an aliphatic epoxy resin and an aromatic epoxy resin. Among these, a bisphenol A type epoxy resin, a bisphenol F type epoxy resin, a bisphenol S type epoxy resin, a biphenyl type epoxy resin, a naphthalene ring-containing epoxy resin, and an aminophenol type epoxy resin are preferable, and a bisphenol A type epoxy resin, a bisphenol F type epoxy resin, a naphthalene ring-containing epoxy resin, an aminophenol type epoxy resin, and a biphenyl type epoxy resin are more preferable.

It is preferable to use a polyfunctional epoxy resin from the viewpoint that the glass transition temperature of the epoxy resin composite material obtained by thermally curing the liquid composition tends to be high. As the polyfunctional epoxy resins, glycidyl ether-type polyfunctional epoxy resins such as epoxy resins produced from various phenols such as phenol novolak resins, cresol novolak resins, bisphenol Anovolak resins, dicyclopentadiene phenol resins, phenol aralkyl resins, naphthol novolak resins, biphenyl novolak resins, terpene phenol resins, and heavy oil-modified phenol resins, and various phenol compounds such as polyhydric phenol resins obtained by a condensation reaction between various phenols and various aldehydes such as hydroxybenzaldehyde, crotonaldehyde, and glyoxal, and epihalohydrin are preferable.

From the viewpoint of fluidity, the epoxy resins used in the present invention preferably have a viscosity at 23°C of 5 Pa ·s or less, and more preferably 0.1 to 3 Pa ·s. The method for measuring the viscosity of epoxy resins is specified in JIS K 7233 (1986), and a single cylinder type rotary viscosimeter method is suitable. The viscosity at 23°C of the epoxy resins used in the present invention may be measured using a B-type rotational viscosimeter ("LVDV-1 Pri", manufactured by Brookfield Engineering Laboratories, Inc., spindle: S62), which is one of the single cylinder type rotary viscosimeter methods.

From the viewpoint of viscosity control, the epoxy equivalent of the epoxy resin is preferably 50 g/equivalent or more and 500 g/equivalent or less, and more preferably 90 g/equivalent or more and 150 g/equivalent or less. The epoxy equivalent is preferably high in terms of excellent heat resistance. On the other hand, when the melting temperature of the epoxy resins is low or the viscosity thereof is low, the filling property of the liquid composition is good, and the bonding property by filling is likely to be high, and thus, the epoxy equivalent is preferably low.

One type of epoxy resin may be used alone, or two or more types of epoxy resins may be mixed and used in an arbitrary combination and ratio, and the epoxy equivalent in the case of mixing is the equivalent of the mixture.

The content of the epoxy resin in the liquid composition of the present invention is preferably small in that the content of the inorganic filler and the like is relatively large and the thermal expansion coefficient is easily reduced. On the other hand, the content of the epoxy resin is preferably large in that the excellent physical properties of the epoxy resin are easily maintained. Specifically, the content of the epoxy resin is preferably 5% by mass or more, and more preferably 10% by mass or more with respect to the total amount of the composition. On the other hand, the content of the epoxy resin is preferably 50% by mass or less, more preferably 25% by mass or less, and particularly preferably 15% by mass or less.

### (Curing Agent)

The liquid composition of the present invention preferably further contains a curing agent. The curing agent refers to a substance that contributes to crosslinking reaction between crosslinking groups of the epoxy resin.

The curing agent is not particularly limited, and a curing agent generally known as an epoxy resin curing agent can be used. Examples of the curing agent include phenol-based curing agents, amine-based curing agents such as aliphatic amines, polyetheramines, alicyclic amines, and aromatic amines, acid anhydride-based curing agents, amide-based curing agents, tertiary amines, imidazole and derivatives thereof, organic phosphines, phosphonium salts, tetraphenylboron salts, organic acid dihydrazides, halogenated boron-amine complexes, polymercaptan-based curing agents, isocyanate-based curing agents, blocked isocyanate-based curing agents, and dicyandiamide compounds. From the viewpoint of imparting fluidity and rapid curability, the curing agent is preferably an acid anhydride-based curing agent.

Specific examples of the phenol-based curing agent include bisphenol A, bisphenol F, 4,4'-dihydroxydiphenylmethane, 4,4'-dihydroxydiphenyl ether, 1,4-bis(4-hydroxyphenoxy)benzene, 1,3-bis(4-hydroxyphenoxy)benzene, 4,4'-dihydroxydiphenyl sulfide, 4,4'-dihydroxydiphenyl ketone, 4,4'-dihydroxydiphenyl sulfone, 4,4'-dihydroxybiphenyl, 2,2'-dihydroxybiphenyl, 10-(2,5-dihydroxyphenyl)- 10H-9-oxa- 10-phosphaphenanthrene- 10-oxide, phenol novolac, bisphenol-A novolac, o-cresol novolac, m-cresol novolac, p-cresol novolac, xylenol novolac, poly-p-hydroxystyrene, hydroquinone, resorcinol, catechol, t-butylcatechol, t-butylhydroquinone, fluoroglycinol, pyrogallol, t-butylpyrogallol, allylated pyrogallol, polyallylated pyrogallol, 1,2,4-benzenetriol, 2,3,4-trihydroxybenzophenone, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,4-dihydroxynaphthalene, 2,5-dihydroxynaphthalene, 2,6-dihydroxynaphthalene, 2,7-dihydroxynaphthalene, 2,8-dihydroxynaphthalene, allylated products or polyallylated products of the above-mentioned dihydroxynaphthalene, allylated bisphenol A, allylated bisphenol F, allylated phenol novolac, and allylated pyrogallol.

Specific examples of the amine-based curing agent include aliphatic amines such as ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, and tetra(hydroxyethyl)ethylenediamine.

Examples of the polyether amines include triethylene glycol diamine, tetraethylene glycol diamine, diethylene glycol bis(propylamine), polyoxypropylene diamine, and polyoxypropylene triamines.

Examples of the alicyclic amine include isophorone diamine, methacene diamine, N-aminoethylpiperazine, bis(4-amino-3-methyldicyclohexyl)methane, bis(aminomethyl)cyclohexane, 3,9-bis(3-aminopropyl)-2,4,8,10-tetraoxaspiro(5,5)undecane, and norbornene diamine.

Examples of the aromatic amine include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-dimethylaminomethylphenol, triethanolamine, methylbenzylamine, α-(m-aminophenyl)ethylamine, α-(p-aminophenyl)ethylamine, diaminodiethyldimethyldiphenylmethane, and α,α'-bis(4-aminophenyl)-p-diisopropylbenzene.

Specific examples of the acid anhydride-based curing agent include dodecenylsuccinic anhydride, polyadipic anhydride, polyazelaic anhydride, polysebacic anhydride, poly(ethyloctadecanedioic acid) anhydride, poly(phenylhexadecanedioic acid) anhydride, methyltetrahydrophthalic anhydride, methylhexahydrophthalic anhydride, hexahydrophthalic anhydride, methylhimic anhydride, tetrahydrophthalic anhydride, trialkyltetrahydrophthalic anhydride, methylcyclohexenedicarboxylic anhydride, methylcyclohexenetetracarboxylic anhydride, phthalic anhydride, trimellitic anhydride, pyromellitic anhydride, benzophenonetetracarboxylic anhydride, ethylene glycol bistrimellitate dianhydride, HET anhydride, nadic anhydride, methylnadic anhydride, 5-(2,5-dioxotetrahydro-3-furanyl)-3-methyl-3-cyclohexane-1,2-dicarboxylic anhydride, 3,4-dimethyl-6-(2-methyl-1-propenyl)-4-cyclohexene-1,2-dicarboxylic anhydride, 3,4-dicarboxy-1,2,3,4-tetrahydro-1-naphthalenesuccinic dianhydride, and 1-methyl-dicarboxy-1,2,3,4-tetrahydro-1-naphthalenesuccinic dianhydride.

Examples of the amide-based curing agent include dicyandiamide and polyamide resin.

Examples of the tertiary amine include 1,8-diazabicyclo(5,4,0)undecene-7, triethylenediamine, benzyldimethylamine, triethanolamine, dimethylaminoethanol, and tris(dimethylaminomethyl)phenol.

Examples of the imidazole and derivatives thereof include 1-cyanoethyl-2-phenylimidazole, 2-phenylimidazole, 2-ethyl-4(5)-methylimidazole, 2-phenyl-4-methylimidazole, 1-benzyl-2-methylimidazole, 1-benzyl-2-phenylimidazole, 1-cyanoethyl-2-undecylimidazole, 1-cyano-2-phenylimidazole, 1-cyanoethyl-2-undecylimidazole trimellitate, 1-cyanoethyl-2-phenylimidazolium trimellitate, 2,4-diamino-6-[2'-methylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, and adducts of epoxy resins with the above-mentioned imidazoles or polymer-encapsulated imidazoles.

Examples of the organic phosphine include tributylphosphine, methyldiphenylphosphine, triphenylphosphine, diphenylphosphine and phenylphosphine; examples of the phosphonium salt include tetraphenylphosphonium tetraphenylborate, tetraphenylphosphonium ethyltriphenylborate, and tetrabutylphosphonium tetrabutylborate; and examples of the tetraphenylboron salt include 2-ethyl-4-methylimidazole tetraphenylborate and N-methylmorpholine tetraphenylborate.

These curing agents may be used alone, or two or more thereof may be used in any combination and at any ratio.

When the liquid composition of the present invention contains a curing agent, the content of the curing agent is preferably in the range of 0.8 to 2.0, and more preferably in the range of 0.8 to 1.5 in terms of the equivalent ratio of the epoxy group in the epoxy resin to the functional group in the curing agent [(functional group in curing agent)/(epoxy group in epoxy resin)] when the curing agent is a phenol-based curing agent, an amine-based curing agent, or an acid anhydride-based curing agent because the curing agent is less likely to be affected by the remaining unreacted epoxy group or the functional group of the curing agent.

When the curing agent is an amide-based curing agent, a tertiary amine, imidazole and a derivative thereof, an organic phosphine, a phosphonium salt, a tetraphenylboron salt, an organic acid dihydrazide, a halogenated boron amine complex, a polymercaptan-based curing agent, an isocyanate-based curing agent, a blocked isocyanate-based curing agent, or the like, the curing agent is preferably used in an amount of 0.1 parts by mass or more, and more preferably 0.5 parts by mass or more, with respect to 100 parts by mass of the epoxy resin. On the other hand, it is preferably used in an amount of 20 parts by mass or less, and more preferably 10 parts by mass or less.

In the case of the dicyandiamide compound, it is preferably used in an amount of 0.1 parts by mass or more, and more preferably 0.5 parts by mass or more, with respect to 100 parts by mass of the epoxy resin. On the other hand, it is preferably used in an amount of 10 parts by mass or less, and more preferably 6 parts by mass or less.

### (Dispersant)

The liquid composition according to the fifth embodiment of the present invention may contain a dispersant in order to enhance the dispersibility of the inorganic filler. The dispersant used in the liquid composition containing a resin and a filler is mainly added to a liquid composition containing a resin and a filler having a large difference in polarity, thereby improving the interface state between the two and improving the compatibility. As a result, effects such as a lowering in viscosity, improvement in dispersibility of the filler, and prevention of aggregation and sedimentation of the filler can be exhibited.

As the dispersant, the same dispersant as that used in the composition according to the fourth embodiment can be used, and the same applies to a preferred range and a commercially available product.

In the fifth embodiment, the content of the dispersant is preferably large from the viewpoint of easily uniformly dispersing the inorganic filler in the liquid composition. On the other hand, the content of the dispersant is preferably small from the viewpoint that an increase in the thermal expansion coefficient due to phase separation between the inorganic filler and the epoxy resin hardly occurs. The content of the dispersant is preferably 0.1% by mass or more and 30% by mass or less and more preferably 0.1% by mass or more and 25% by mass or less with respect to the total amount of the liquid composition because it is easy to fill a narrow space with the liquid composition and to obtain a low thermal expansion coefficient after curing.

### (Reactive Diluent)

The liquid composition of the present invention may contain a reactive diluent. The reactive diluent is not particularly limited as long as it contains at least one monofunctional epoxy compound. The monofunctional epoxy compound is an epoxy compound having one epoxy group, and has been conventionally used as a reactive diluent for adjusting the viscosity of an epoxy resin composition. The monofunctional epoxy compound is roughly classified into an aliphatic monofunctional epoxy compound and an aromatic monofunctional epoxy compound, and is preferably an aromatic monofunctional epoxy compound from the viewpoint of viscosity.

### (Other Additives)

In addition to the above, the liquid composition may appropriately contain other additives selected from a coupling agent, an ultraviolet inhibitor, an antioxidant, a plasticizer, a flame retardant, a colorant, a fluidity improving agent, a defoaming agent, an ion trapping agent, and the like.

In the present embodiment, the liquid composition is preferably a solventless liquid composition. By using a solventless liquid composition, it is possible to prevent the occurrence of voids and the like due to volatilization of the solvent when the liquid composition is heated and cured. The solvent is a volatile component, and in the description herein, is a term including water and an organic solvent. The solventless liquid composition does not substantially contain a solvent, and for example, the content of the solvent is preferably less than 3% by mass, more preferably less than 1% by mass, and most preferably 0% by mass with respect to the total amount of the liquid composition.

### (Viscosity of Liquid Composition)

The liquid composition is a composition having fluidity at room temperature (23°C). The viscosity of the liquid composition according to the fifth embodiment of the present invention is preferably low in that the composition can be easily filled even in a narrow space. On the other hand, the viscosity of the liquid composition is preferably high from the viewpoint that dripping or the like hardly occurs at the time of filling the composition. The viscosity of the liquid composition at 23°C is preferably 0.1 Pa ·s or more, more preferably 1 Pa ·s or more, still more preferably 5 Pa ·s or more, and particularly preferably 10 Pa ·s or more. On the other hand, the viscosity of the liquid composition at 23°C is preferably 250 Pa ·s or less, more preferably 200 Pa ·s or less, still more preferably 150 Pa ·s or less, and particularly preferably 30 Pa ·s or less.

The viscosity of the liquid composition can be measured in the same manner as in the method for measuring the viscosity of the epoxy resin described above. The viscosity at 23°C of the liquid composition used in the present invention may be measured using a B-type rotational viscosimeter, which is one of single cylinder type rotary viscosimeter methods. As the B-type rotational viscosimeter, for example, one described in Examples may be used.

### (Average Thermal Expansion Coefficient)

The average thermal expansion coefficient (CTE1) of a cured product of the liquid composition according to the fifth embodiment of the present invention is preferably low from the viewpoint that the epoxy resin composite material is less likely to be deformed by an ambient temperature environment, heat generation, or the like. On the other hand, the average thermal expansion coefficient of the liquid composition is preferably close to that of the surrounding members from the viewpoint that breakage or the like due to a difference in average thermal expansibility between the liquid composition and the surrounding members is less likely to occur. Therefore, when the liquid composition is used as an underfill material or the like in the production of semiconductor devices, the thermal expansion coefficient of the liquid composition is preferably close to the average thermal expansion coefficient (for example, 3 to 4 ppm/K) of semi-conductor substrates.

From the above viewpoint, in the liquid composition according to the fifth embodiment of the present invention, the average thermal expansion coefficient (CTE1) of the cured product is preferably 0 ppm/K or more, more preferably 2 ppm/K or more, still more preferably 4 ppm/K or more, and particularly preferably 10 ppm/K or more. On the other hand, it is preferably 200 ppm/K or less, more preferably 100 ppm/K or less, and particularly preferably 30 ppm/K or less.

The average thermal expansion coefficient and the glass transition temperature (Tg) to be described later of the cured product obtained by curing the liquid composition may be obtained by measuring the average thermal expansion coefficient of the epoxy resin composite material (cured product) obtained by curing the liquid composition to have a gel fraction of 80% or more. The average thermal expansion coefficient (CTE1) is obtained from a slope of a tangent line obtained by measuring a temperature change of a change amount of sample lengths at 25 to 100°C by a compression method based on thermomechanical analysis in accordance with JIS K 7197 (2012). Specific measurement conditions of the average thermal expansion coefficient are as described in Examples.

### (Glass Transition Temperature)

The glass transition temperature (Tg) of the epoxy resin composite material obtained by curing the liquid composition according to the fifth embodiment of the present invention is not particularly limited. For example, when the underfill material has a high Tg, it is said that the portion sealed with the underfill material has high bump protection at high temperature and excellent thermal cycle resistance, which is preferable (see, for example, JP 2017-110146 A). From such a viewpoint, the cured product of the liquid composition according to the fifth embodiment has a glass transition temperature (Tg) of preferably 50°C or higher, and more preferably 80°C or higher.

In addition, when the glass transition temperature is 150°C or lower, warpage at room temperature (23°C) tends to be less likely to increase. Therefore, the glass transition temperature (Tg) is preferably 50 to 150°C, and more preferably 80 to 150°C. It should be noted that the glass transition temperature (Tg) can be measured by a thermomechanical analyzer (TMA). Specifically, the glass transition temperature (Tg) can be measured by a method described in Examples.

### (Method for Producing Liquid Composition)

The liquid composition according to the fifth embodiment of the present invention can be generally obtained by mixing and kneading an epoxy resin, an inorganic filler, and a curing agent, a dispersant, a reactive diluent, and other additive components, which are used as necessary, using a vacuum mixer, a mixing roll, a planetary mixer, or the like, and defoaming the mixture as necessary. The order of blending these components is arbitrary as long as there is no particular problem such as reaction or generation of a precipitate, and any two components or three or more components among the constituent components may be mixed in advance, and then the remaining components may be mixed, or all of the components may be mixed at once.

In addition, for example, by using a zeolite having a particle size of 1.0 µm or more and 10 µm or less and an inorganic filler having a particle size of 0.1 µm or more and less than 1.0 µm as raw materials producing a liquid composition, a large particle size zeolite and a small particle size inorganic filler produced by the above-described method may be contained in the liquid composition, or a large particle size zeolite and a small particle size inorganic filler produced by another method may be contained in the liquid composition.

### <Epoxy Resin Composite Material>

The epoxy resin composite material according to the fifth embodiment of the present invention can be obtained by curing the above-described liquid composition. The epoxy resin composite material according to the fifth embodiment is an epoxy resin composite material containing an epoxy resin and an inorganic filler, in which the inorganic filler contains a zeolite having a particle size of 1.0 µm or more and 10 µm or less (large particle size zeolite) and an inorganic filler having a particle size of 0.1 µm or more and less than 1.0 µm (small particle size inorganic filler). The epoxy resin composite material according to the fifth embodiment contains the large particle size zeolite and the small particle size inorganic filler, and thus can be produced from a liquid composition having a relatively low viscosity while lowering the thermal expansion coefficient.

In the epoxy resin composite material according to the fifth embodiment of the present invention, the epoxy resin and the inorganic filler are as described above. In addition, the epoxy resin composite material may appropriately contain components contained in the liquid composition in addition to the epoxy resin and the inorganic filler. The content of each component in the epoxy resin composite material is as described above except that the total amount of the epoxy resin composite material is used as a reference instead of the total amount of the liquid composition. Further, the epoxy resin composite material is preferably cured to have a gel fraction of 80% or more, and is preferably cured by the curing agent contained in the liquid composition.

From the same viewpoint as described above, the preferred ranges of the average thermal expansion coefficient (CTE 1) and the glass transition temperature of the epoxy resin composite material according to the fifth embodiment of the present invention are the same as the preferred ranges when the liquid composition is formed into a cured product, as described above. In addition, the average thermal expansion coefficient and the glass transition temperature of the epoxy resin composite material can be measured by the above described measurement method.

### (Method for Producing Epoxy Resin Composite Material)

The epoxy resin composite material can be obtained by curing the liquid composition. The curing is preferably curing by heating. The method for producing the epoxy resin composite material is not particularly limited as long as the epoxy resin composite material exhibits preferable performance, and the method can be appropriately performed using a known method according to the blending component composition of the liquid composition and the like.

The epoxy resin composite material is preferably molded by, for example, filling the liquid composition in a gap between constituent members of various products such as an electronic device and curing the liquid composition. Further, the epoxy resin composite material may be molded by applying the liquid composition to constituent members of various products and curing the liquid composition.

Alternatively, the epoxy resin composite material may be molded by curing the liquid composition in a desired shape, for example, in a state in which the liquid composition is accommodated in a mold. In the production of such a molded body, injection molding, injection compression molding, extrusion molding, or compression molding can be used. In addition, molding, that is, curing of the epoxy resin composite material can be performed under each curing temperature condition. In addition, the epoxy resin composite material can also be obtained by cutting a cured product of the liquid composition into a desired shape.

The heating temperature at the time of thermal curing is affected by the curing agent and the like to be used and is not particularly limited, but is usually 30°C or higher, preferably 50°C or higher, more preferably 60°C or higher, and still more preferably 80°C or higher. On the other hand, the heating temperature is usually 400°C or lower, preferably 350°C or lower, more preferably 300°C or lower, and still more preferably 250°C or lower. When the curing temperature is within the above range, a high-quality resin composite material can be easily obtained in a short time.

### [Sixth Embodiment]

Next, a sixth embodiment of the present invention will be described. The liquid composition according to the sixth embodiment of the present invention contains an epoxy resin, an inorganic filler, and a dispersant, and contains at least a zeolite as the inorganic filler. Components other than the epoxy resin, the inorganic filler, the zeolite, and the dispersant contained in the liquid composition according to the sixth embodiment of the present invention are the same as those in the composition according to the fifth embodiment of the present invention. However, in the present embodiment, a dispersant having at least one functional group of an amino group and an amine salt is used as the dispersant.

### (Dispersant)

The present inventors have found that in a liquid composition containing an epoxy resin and a zeolite filler, a dispersant containing at least an amino group or an amine salt is excellent from the viewpoint of reducing the viscosity. Therefore, as the dispersant used in the sixth embodiment of the present invention, a dispersant having at least one functional group of an amino group and an amine salt is used. The dispersant preferably has an amino group at a terminal thereof from the viewpoint of a reduction in the viscosity of the liquid composition. The amine salt may be modified with an acid group such as phosphoric acid. In the sixth embodiment of the present invention, by using the specific dispersant, it is possible to prevent an increase in the viscosity of the liquid composition while using a zeolite as the inorganic filler in the present embodiment.

The dispersant is preferably a polymer dispersant, and the details of the polymer dispersant are as described above, but from the viewpoint of storage stability, a block structure or a comb structure is particularly preferable. The dispersant is preferably a solventless type dispersant containing no solvent, particularly preferably a solventless type polymer dispersant.

Also in the sixth embodiment, a commercially available product can be used as the dispersant. As the commercially available product, a dispersant having at least one functional group of an amino group and an amine salt among the dispersants listed in the fifth embodiment may be used.

The content of the dispersant is also the same as in the fifth embodiment.

The zeolite in the liquid composition according to the sixth embodiment is the same as that in the liquid composition according to the fifth embodiment except for the particle size and the content of the zeolite contained therein.

The zeolite contained in the liquid composition is not particularly limited, but the particle size thereof is preferably 0.1 µm or more and 10 µm or less, and more preferably 1 µm or more and 10 µm or less. An increase in the viscosity of the liquid composition can be further suppressed by increasing the particle size of the zeolite contained in the liquid composition.

The content of the zeolite in the liquid composition according to the sixth embodiment is preferably 20% by mass or more, more preferably 25% by mass or more, still more preferably 30% by mass or more, particularly preferably 40% by mass or more, and even more preferably 45% by mass or more, and is preferably 90% by mass or less, more preferably 80% by mass or less, still more preferably 75% by mass or less, and particularly preferably 70% by mass or less, with respect to the total amount of the liquid composition, from the viewpoint of lowering the thermal expansion coefficient while suppressing an increase in the viscosity.

Details of the epoxy resin and the zeolite other than the above-described content and particle size are as described in the fifth embodiment. Furthermore, as described above, the zeolite according to the sixth embodiment preferably contains a large particle size zeolite, and the content and other details of the large particle size zeolite are the same as those in the fifth embodiment, and thus detailed description thereof will be omitted. Also in the present embodiment, when the large particle size zeolite is contained in a predetermined amount or more, it becomes easy to prevent the viscosity of the liquid composition from increasing.

The inorganic filler in the liquid composition may contain an inorganic filler other than a zeolite. Details of the inorganic filler other than a zeolite are the same as those in the fifth embodiment.

Further, also in the sixth embodiment, the inorganic filler preferably contains a large particle size zeolite and a small particle size inorganic filler as in the fifth embodiment. Details of the large particle size zeolite and the small particle size inorganic filler in this case are as described in the fifth embodiment.

Further, as in the fifth embodiment, the liquid composition according to the sixth embodiment preferably contains a curing agent, and may contain a reactive diluent, other additives, or the like, and these components are as described above. In addition, the liquid composition according to the sixth embodiment is also preferably a solventless system, and the details thereof are as described above.

The epoxy resin composite material according to the sixth embodiment of the present invention is obtained by curing the above-described liquid composition to have a gel fraction of 80% or more. More specifically, the epoxy resin composite material is an epoxy resin composite material containing an epoxy resin, a zeolite, and a dispersant having at least one functional group of an amino group and an amine salt. As described above, the epoxy resin composite material according to the present embodiment can prevent the viscosity of the liquid composition for obtaining the epoxy resin composite material from increasing by containing the dispersant.

In the epoxy resin composite material according to the sixth embodiment of the present invention, the epoxy resin, the zeolite, and the dispersant are as described above. In addition, the epoxy resin composite material may appropriately contain components contained in the liquid composition according to the sixth embodiment in addition to the epoxy resin, the zeolite, and the dispersant. The content of each component in the epoxy resin composite material is as described above except that the total amount of the epoxy resin composite material is used as a reference instead of the total amount of the liquid composition. Further, in the epoxy resin composite material, the epoxy resin may be cured to have a gel fraction of 80% or more, and is preferably cured by the curing agent contained in the liquid composition described above.

In the sixth embodiment, various physical properties of the liquid composition and the epoxy resin composite material, and the method for producing the same are as described in the fifth embodiment. Therefore, the viscosity of the liquid composition according to the sixth embodiment, the average thermal expansion coefficient and the glass transition temperature when the liquid composition is formed into a cured product, and the average thermal expansion coefficient and the glass transition temperature of the epoxy resin composite material according to the sixth embodiment are as described in the fifth embodiment.

### [Seventh Embodiment]

A seventh embodiment of the present invention is an epoxy resin composite material containing a zeolite as an inorganic filler and having a low average thermal expansion coefficient. Hereinafter, the seventh embodiment of the present invention will be described.

To be specific, the epoxy resin composite material according to the seventh embodiment is an epoxy resin composite material containing an epoxy resin and an inorganic filler, and has an average thermal expansion coefficient of 0 ppm/K or more and 200 ppm/K or less, and the inorganic filler contains a zeolite. As described above, the average thermal expansion coefficient is more preferably 2 ppm/K or more, and particularly preferably 4 ppm/K or more, and is more preferably 100 ppm/K or less, and particularly preferably 30 ppm/K or less.

In the seventh embodiment of the present invention, since the inorganic filler contains a zeolite, the average thermal expansion coefficient can be lowered as described above. From such a viewpoint, the content of the zeolite in the seventh embodiment is preferably 20% by mass or more, more preferably 25% by mass or more, still more preferably 30% by mass or more, particularly preferably 40% by mass or more, and most preferably 45% by mass or more with respect to the total amount of the epoxy resin composite material. On the other hand, from the viewpoint of suppressing an increase in the viscosity of the liquid composition for obtaining the epoxy resin composite material, the content is preferably 90% by mass or less, more preferably 80% by mass or less, still more preferably 75% by mass or less, and particularly preferably 70% by mass or less.

In addition, the epoxy resin in the epoxy resin composite material according to the seventh embodiment is preferably 5% by mass or more, and more preferably 10% by mass or more, with respect to the total amount of the epoxy resin composite material, from the viewpoint that the thermal expansion coefficient is easily lowered, and further, the excellent physical properties of the epoxy resin are easily maintained. On the other hand, the epoxy resin is preferably 50% by mass or less, more preferably 25% by mass or less, and particularly preferably 15% by mass or less.

The seventh embodiment of the present invention also provides a liquid composition for obtaining the epoxy resin composite material. To be specific, the liquid composition according to the seventh embodiment is a liquid composition containing an epoxy resin and an inorganic filler, in which when the composition is formed into a cured product having a gel fraction of 80% or more, the cured product has an average thermal expansion coefficient of 0 ppm/K or more and 200 ppm/K or less, and the inorganic filler contains a zeolite. The method for measuring the average thermal expansion coefficient and the preferable range thereof are the same as those of the epoxy resin composite material.

The liquid composition according to the seventh embodiment preferably has a viscosity at 23°C of 0.1 Pa.s or more and 250 Pa ·s or less. This makes it possible to reduce the viscosity of the cured product while reducing the thermal expansion coefficient of the cured product. The preferable range of the viscosity of the liquid composition at 23°C is as described in the first embodiment.

In the seventh embodiment, details other than the contents of the epoxy resin and the zeolite are as described in the fifth embodiment. Further, as described above, the inorganic filler according to the seventh embodiment preferably contains a large particle size zeolite, and the content and other details of the large particle size zeolite are the same as those in the fifth embodiment, and thus description thereof will be omitted.

In addition, the inorganic filler may contain an inorganic filler other than a zeolite. Details of the inorganic filler other than a zeolite are the same as those in the fifth embodiment.

Further, as in the fifth embodiment, the liquid composition according to the seventh embodiment preferably contains a curing agent, and may contain a reactive diluent, other additives, or the like, and these components are as described above. In addition, the liquid composition according to the seventh embodiment is also preferably a solventless system, and the details thereof are as described above.

Further, also in the seventh embodiment, the inorganic filler preferably contains a large particle size zeolite and a small particle size inorganic filler as in the fifth embodiment. Furthermore, also in the seventh embodiment, the liquid composition or the epoxy resin composite material preferably further contains a specific dispersant (a dispersant having at least one functional group of an amino group and an amine salt) as in the sixth embodiment. These aspects are as described in the fifth and sixth embodiments.

### (Use)

The composition and the resin composite material of the present invention can be used for, for example, a catalyst module, a molecular sieve membrane module, an optical member, a moisture-absorbing member, food, a building member, and a constituent member or a packaging member of an electronic device, and among them, the composition and the resin composite material are preferably used for an electronic device. Therefore, the present invention provides, as a preferred aspect, an electronic device containing a resin composite material, and more preferably, an electronic device containing an epoxy resin composite material.

The electronic device is a device which has two or more electrodes and controls a current flowing between the electrodes or a voltage generated between the electrodes by electricity, light, magnetism, a chemical substance, or the like, or a device which generates light, an electric field, or a magnetic field by an applied voltage or current. Specific examples thereof include a resistor, a rectifier (diode), a switching element (transistor or thyristor), an amplifier element (transistor), a memory element, a chemical sensor, and a device obtained by combining or integrating these elements. Further, a photodiode or a phototransistor which generates a photocurrent, an electroluminescent element which emits light by application of an electric field, and an optical element such as a photoelectric conversion element or a solar cell which generates an electromotive force by light can also be given. The electronic device is preferably a semiconductor device. The semiconductor device preferably includes at least a semiconductor substrate, and examples thereof include a device in which a semiconductor chip is mounted on a substrate and a device in which semiconductor chips or semiconductor substrates are stacked in multiple layers.

The liquid composition of the present invention is preferably used as a liquid sealing agent, and in this case, an epoxy resin composite material formed by curing the liquid composition is preferably used as a sealing material.

The liquid sealing agent is preferably used as a sealing material which fills a gap formed in a constituent member and is then cured to fill the gap.

In addition, the liquid sealing agent may be used as a sealing material for filling a gap between constituent members, for example, by applying the liquid sealing agent onto various constituent members, stacking another constituent member on the liquid sealing agent, and then appropriately curing the liquid sealing agent. At this time, the liquid sealing agent may be appropriately cured to be in a B stage before another constituent member is stacked.

Among these, the liquid composition of the present invention is preferably used for an application in which the composition is filled in a gap and cured. That is, the sealing material is preferably produced by filling the liquid composition of the present invention into a gap and then curing the liquid composition. The liquid composition of the present invention has a low viscosity and can be filled into a narrow gap without causing voids or the like.

The liquid composition of the present invention is preferably used as a liquid sealing material, and particularly preferably used as an underfill material. The underfill material is preferably used in the production of an electric device, particularly a semiconductor device, and is preferably used for filling a gap formed between a substrate and a semiconductor chip, between substrates, between semiconductor chips, or the like, for example. As the substrate, a known substrate can be used, and a substrate made of an organic material such as an epoxy resin substrate or a phenol resin substrate may be used. In addition, the semiconductor chip may be formed of a semiconductor substrate such as a silicon substrate.

The cured product of the liquid composition of the present invention has a low thermal expansion coefficient, and when the liquid composition is used as an underfill material, the difference in thermal expansion coefficient between the cured product and a semiconductor substrate or the like is reduced, and thus the thermal cycle resistance and the like are improved.

For example, in a laminate in which a semiconductor chip is mounted on a substrate, the underfill material is preferably used as a sealing material that is filled in a gap between the substrate and the semiconductor chip and then cured by heating to seal the gap between the substrate and the chip. In this case, before the underfill material is filled, for example, the bonding may be performed on the front face of the substrate on which the wiring pattern is formed via the bump by reflow or the like.

The underfill material may be used in the production of a semiconductor device by a pre-apply method. Specifically, on the surface of a semiconductor chip on which a plurality of bumps are formed, the underfill material is filled between the plurality of bumps to form an underfill layer. Here, the filled underfill material may be B-staged as necessary. Thereafter, the semiconductor chip on which the underfill layer is formed may be placed on the front surface of the substrate such that the surface on which the underfill layer is formed faces the substrate. Next, the underfill layer may be cured by heating and pressing or the like to become a sealing material, and the semiconductor chip may be subjected to bonding on the front surface of the substrate on which the wiring pattern is formed via the bumps.

Further, in the pre-apply method, the underfill material may be applied onto the front surface of the substrate on which the wiring pattern is formed to form the underfill layer. Here, the applied underfill layer may be B-staged as necessary. Thereafter, the semiconductor chip on which the bumps are formed may be placed on the substrate on which the underfill layer is formed such that the surface on which the bumps are formed faces the front surface of the substrate on which the underfill layer is formed. Thereafter, the underfill layer may be cured by heating and pressing or the like to become a sealing material, and the semiconductor chip may be subjected to bonding on the front surface of the substrate on which the wiring pattern is formed via the bumps.

In the above description, an example in which the underfill material is used as a sealing material for filling a gap between a substrate and a semiconductor chip has been described. However, the use of the underfill material is not particularly limited, and the underfill material may be used for filling a gap between semiconductor chips or may be used as a sealing material for filling a gap between substrates. In addition, the substrate is not limited to a substrate made of an organic material, and may be a semiconductor substrate or the like.

### Examples

Hereinafter, the present invention will be further described in detail with reference to Examples, Comparative Examples, and Reference Examples, but the present invention is not limited to the following Examples, Comparative Examples, and Reference Examples as long as the gist of the present invention is not deviated.

### <Synthesis of Zeolite>

### [Example 1]

### (Production of Zeolite Filler A1)

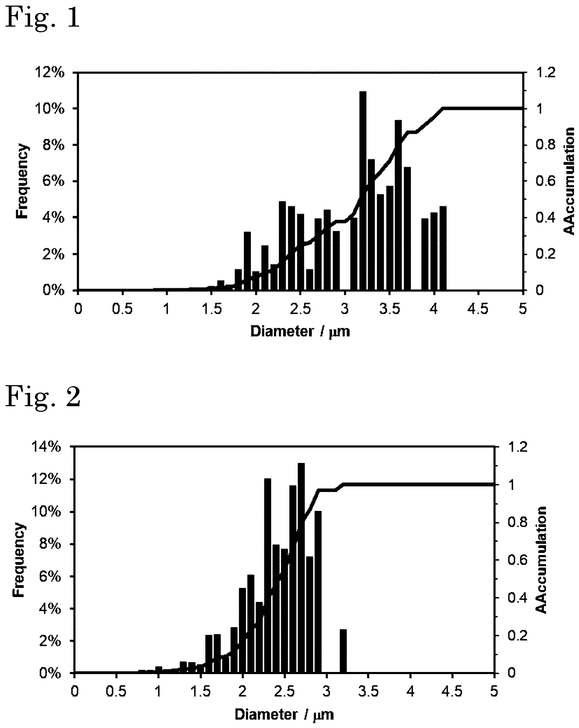

N,N,N-trimethyl-1-adamantylammonium hydroxide (TMAdaOH) manufactured by SACHEM, Inc. as a structure directing agent (SDA), "KYOWAAD 200S" manufactured by Kyowa Chemical Industry Co., Ltd. as an aluminum hydroxide, and "AEROSIL200" manufactured by Nippon Aerosil Co., Ltd. as silica were sequentially added to a container. The composition and the molar ratio of the obtained mixture were SiO₂:Al₂O₃:TMAdaOH:H₂O = 1.0:0.025:0.4:20. After mixing well, the obtained mixture was placed in a pressure-resistant container, and hydrothermal synthesis was performed in an oven at 150°C for 48 hours. The mixture was subjected to suction filtration, washed, and then dried. The obtained powder was fired at 600°C for 6 hours under air flow to remove TMAdaOH as a structure directing agent (SDA), thereby obtaining a CHA-type zeolite. The obtained zeolite was a zeolite having a particle size distribution as shown in Fig. 1, in which the particle size of each particle was in a range of 1.0 µm or more and 10 µm or less, and the average primary particle size thereof was 3.1 µm. The average primary particle size was set as an average value of the particle sizes of 50 primary particles selected at random. The average thermal expansion coefficient at 50 to 100°C was -9.0 ppm/K, the average thermal expansion coefficient at 50 to 350°C was -17.0 ppm/K, the Si/Al₂ ratio was 27.8, the sphericity was 0.85, the roundness was 0.845, the c-axis length was 14.67 Å, and the counter cation was a proton type.

### [Example 2]

### (Production of Zeolite Filler A2)

A CHA-type zeolite was obtained in the same manner as in Example 1 except that in the step of the hydrothermal synthesis in Example 1, the hydrothermal synthesis was performed while rotating the heat-resistant container. The obtained zeolite was particles having a particle size distribution as shown in Fig. 2, and 99% of the particles on a volume basis had a particle size within a range of 1.0 µm or more and 10 µm or less. The average primary particle size was 2.4 µm. The measurement of the average primary particle size was performed in the same manner as in Example 1. The average thermal expansion coefficient at 50 to 100°C was -9.0 ppm/K, the average thermal expansion coefficient at 50 to 350°C was -12.1 ppm/K, the Si/Al₂ ratio was 27.8, the sphericity was 0.82, the roundness was 0.829, the c-axis length was 14.59 Å, and the counter cation was a proton type.

### [Example 3]

### (Production of Zeolite Filler A3)

A CHA-type zeolite was obtained by hydrothermally synthesizing, drying, and firing in the same manner as in Example 2, except that the composition and molar ratio of the raw material mixture were changed to SiO₂:Al₂O₃:TMAdaOH:H₂O = 1.0:0.020:0.4:20. The obtained zeolite was particles in which 81% of the particles on a volume basis had a particle size within a range of 1.0 µm or more and 10 µm or less. The average primary particle size was 1.2 µm. The measurement of the average primary particle size was performed in the same manner as in Example 1. The average thermal expansion coefficient at 50 to 100°C was -13.7 ppm/K, the average thermal expansion coefficient at 50 to 350°C was -12.9 ppm/K, the Si/Al₂ ratio was 28.2, the sphericity was 0.84, the roundness was 0.835, the c-axis length was 14.59 Å, and the counter cation was a proton type.

### [Comparative Example 1]

### (Production of Zeolite Filler A4)

N,N,N-trimethyl-1-adamantylammonium hydroxide (TMAdaOH) manufactured by SACHEM, Inc. as a structure directing agent (SDA), and aluminum hydroxide manufactured by FUJIFILM Wako Pure Chemical Corporation were sequentially added to a container, and after aging for 12 hours at 80°C, "CAB-O-SIL M-5" manufactured by Cabot Corporation was added as silica. The composition and the molar ratio of the obtained mixture were SiO₂:Al₂O₃:TMAdaOH:H₂O = 1.0:0.025:0.4:20. After mixing well, the obtained mixture was placed in a pressure-resistant container, and hydrothermal synthesis was performed in an oven at 150°C for 48 hours. By suction filtration and washing, a CHA-type zeolite was obtained. The obtained zeolite was a zeolite in which the particle size of each particle was in a range of 1.0 µm or more and 10 µm or less, and the average primary particle size thereof was 3.1 µm. The measurement of the average primary particle size was performed in the same manner as in Example 1. The average thermal expansion coefficient at 50 to 100°C was -5.0 ppm/K, and TMAdaOH was decomposed when heated to 300°C or higher, so that the average thermal expansion coefficient at 50 to 350°C could not be measured. The Si/Al₂ ratio was 27.8, the sphericity was 0.84, the roundness was 0.840, and the c-axis length was 14.87 Å.

### [Comparative Example 2]

### (Production of Zeolite Filler A5)

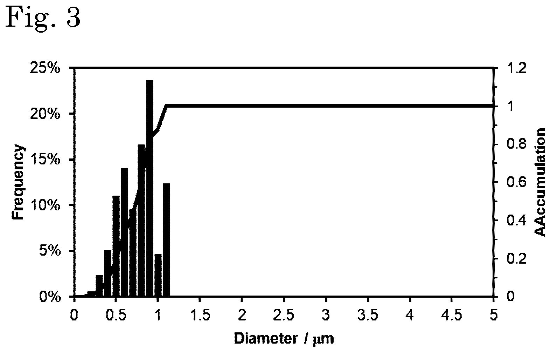

N,N,N-trimethyl-1-adamantylammonium hydroxide (TMAdaOH) manufactured by SACHEM, Inc. as a structure directing agent (SDA), sodium hydroxide manufactured by Kishida Chemical Co., Ltd., potassium hydroxide manufactured by Kishida Chemical Co., Ltd., aluminum hydroxide manufactured by Sigma-Aldrich Co. LLC and "SNOWTEX 40" manufactured by Nissan Chemical Corporation as silica were sequentially added to a container. The composition and the molar ratio of the obtained mixture were SiO₂Al₂O₃:NaOH:KOH:TMAdaOH:H₂O = 1.0:0.033:0.1:0.06:0.07:20. As a seed crystal, 2% by mass of a CHA-type zeolite was added to SiO₂ and mixed well, and then the obtained mixture was placed in a pressure-resistant container, and hydrothermal synthesis was performed in an oven at 160°C for 48 hours while rotating the heat-resistant container. The powder obtained by suction filtration and washing was fired at 600°C for 6 hours under air flow to remove the structure directing agent, thereby obtaining a CHA-type zeolite. The obtained zeolite was particles having a particle size distribution as shown in Fig. 3, and 17% of the particles on a volume basis had a particle size within a range of 1.0 µm or more and 10 µm or less. The average primary particle size was 0.5 µm. The measurement of the average primary particle size was performed in the same manner as in Example 1. The average thermal expansion coefficient at 50 to 100°C was -4.9 ppm/K, the average thermal expansion coefficient at 50 to 350°C was -5.87 ppm/K, the Si/Al₂ ratio was 20.0, and the shape was cubic. The sphericity was 0.59, the roundness was 0.785, the c-axis length was 14.83 Å, and the counter cation was a sodium or potassium type.

The results of Examples 1 to 3 and Comparative Examples 1 and 2 are summarized in Table 1.

**Table 1**

| | | Example 1 | Example 2 | Example 3 | Comparative Example 1 | Comparative Example 2 |
|---|---|---|---|---|---|---|
| Zeolite | | A1 | A2 | A3 | A4 | A5 |
| Particle size (µm) | | 1.0 to 10 | 1.0 to 10 | 1.0 to 10 | 1.0 to 10 | - |
| Average primary particle size (µm) | | 3.1 | 2.4 | 1.2 | 3.1 | 0.5 |
| Thermal exp ansion coefficient (ppm) | 50 to 100°C | -9.0 | -9.0 | -13.7 | -5.0 | -4.9 |
| | 50 to 350°C | -17.0 | -12.1 | -12.9 | - | -5.87 |
| Si/Al₂ ratio | | 27.8 | 27.8 | 28.2 | 27.8 | 20.0 |
| Sphericity | | 0.85 | 0.82 | 0.84 | 0.84 | 0.59 |
| Roundness | | 0.845 | 0.829 | 0.835 | 0.840 | 0.785 |
| c-axis length (A) | | 14.67 | 14.59 | 14.59 | 14.87 | 14.83 |

From the results in Table 1, it can be seen that the zeolite according to the first embodiment of the present invention has a large average primary particle size, and is spherical from the results of the sphericity and the roundness. In addition, since the thermal expansion coefficient is large in the negative direction, it can be seen that the thermal shrinkage ratio is large. Therefore, it is considered that a resin composite material in which thermal expansion is suppressed can be obtained by using the zeolite in combination with a resin.

On the other hand, the zeolite of Comparative Example 1, which was not fired after hydrothermal synthesis, had a c-axis length similar to that of the zeolite of Comparative Example 2, which was produced by a conventional production method. In contrast, the zeolite of Example 1, which was produced by hydrothermal synthesis followed by firing, had a shorter c-axis length. Therefore, it is assumed that the thermal expansion coefficient of the zeolite of the present invention became low due to the short c-axis length.

Next, Examples of the composition and the resin composite material of the present invention are shown below.

### <Blending Components>

The blending components used for preparation of the liquid composition and the resin composite material are as follows.

### <Inorganic Filler>

As zeolite fillers A1, A3, and A4, the zeolite filler A1, A3, or A4 produced in the above Examples was used.

The inorganic fillers other than the zeolite fillers A1 to A5 are as follows.

Silica filler A: product name "HL-3100" manufactured by Tatsumori Ltd., (average particle size: 45 pm, true spherical silica filler).

Silica filler B: product name "SC2053-SQ" manufactured by Admatechs Company Limited (silica having an average particle size of 0.5 µm and a particle size of each particle in a range of 0.1 µm or more and less than 1.0 pm, sphericity: 0.95).

Zeolite filler B: (CHA zeolite in which the particle size of each particle is in a range of less than 1.0 pm, average primary particle size: 0.1 to 0.2 pm, sphericity: 0.58).

### <Epoxy Resin>

Product name"jER630" manufactured by Mitsubishi Chemical Corporation (p-aminophenol type epoxy resin, epoxy equivalent: 97 g/equivalent).

### <Polyimide Powder>

Product name"UIP-R" manufactured by Ube Industries, Ltd. (polyimide, average particle size: 7 pm, specific weight: 1.39).

### <Curing Agent>

Acid anhydride-based curing agent: product name "HN-2200" (methyltetrahydrophthalic anhydride, amine equivalent: 83 g/equivalent) manufactured by Hitachi Chemical Company, Ltd.

### <Dispersant>

Dispersant A: wet dispersant, product name "DISPERBYK-2152" (amino group-containing ultra-high molecular weight polyester, comb type, solventless), manufactured by BYK Japan KK.

Dispersant B: wet dispersant, product name "DISPERBYK-145" (comb-shaped polymer polyester terminal phosphate-modified amine salt, solventless), manufactured by BYK Japan KK.

Dispersant C: wet dispersant, product name "BYK-W9010" (phosphoric acid polyester, solventless), manufactured by BYK Japan KK.

### (Physical Property Evaluation)

The physical property evaluation was performed as follows.

### (Gel Fraction)

The gel fraction of the resin composite material was measured by the following procedure. A resin composite material sample produced under a curing condition of 80°C for 2 hours and then 120°C for 2 hours was cut out in a range of 0.5 to 0.6 g, and placed on a wire net. The wire net was allowed to stand for 24 hours in a state of being immersed in acetone. Thereafter, the wire net was taken out from the acetone, and was subjected to vacuum drying. The ratio of the weight of the sample after immersion to the weight before immersion was defined as the gel fraction.

### (Viscosity of Liquid Composition)

The viscosity of the liquid composition at 23°C was measured using a B-type rotational viscosimeter. As the B-type rotational viscosimeter, "LVDV-1 Pri" manufactured by Brookfield Engineering Laboratories, Inc., spindle: S64 or S63 was used when the viscosity was 0.1 to 100 Pa -s, and "HBDV-E" manufactured by Brookfield Engineering Laboratories, Inc., spindle: S-07 was used when the viscosity was more than 100 Pa ·s. The value measured at 20 rpm was taken as a representative value of the viscosity of each sample.

### (Average Thermal Expansion Coefficient (CTE1) of Epoxy Resin and Epoxy Resin Composite Material)

The average thermal expansion coefficient of the epoxy resin composite material obtained by curing the liquid composition to have a gel fraction of 80% or more was measured by thermomechanical analysis according to a method in accordance with JIS K 7197 (2012). The average thermal expansion coefficient was measured by a compression method using a thermomechanical analyzer (apparatus name: TMA SS7100, manufactured by SII Nanotechnology Inc.). To be specific, the epoxy resin composite material was cut out into a size of ϕ 6 mm × 10 mm, and subjected to temperature drop measurement at 5°C/min from 200°C to 20°C by a compression method using a thermomechanical analyzer. The temperature change of the amount of change in sample lengths at 25 to 100°C was measured, and the slope of the tangent line was defined as the average thermal expansion coefficient (CTE1).

### (Average Thermal Expansion Coefficient (CTE1) of Polyimide Resin and Polyimide Resin Composite Material)

The average thermal expansion coefficient of the polyimide resin composite obtained by curing the liquid composition to have a gel fraction of 80% or more was measured by thermomechanical analysis according to a method in accordance with JIS K 7197 (2012). The average thermal expansion coefficient was measured by a compression method using a thermomechanical analyzer (apparatus name: TMA SS7100, manufactured by SII Nanotechnology Inc.). To be specific, the polyimide resin composite material was cut out into a size of 10 mm in lateral width, 6 mm in thickness, and 10 mm in height, and subjected to temperature drop measurement at 5°C/min from 200°C to 20°C by a compression method using a thermomechanical analyzer. The temperature change of the amount of change in sample lengths at 25 to 100°C was measured, and the slope of the tangent line was defined as the average thermal expansion coefficient (CTE1).

### (Glass Transition Temperature of Epoxy Resin Composite Material)

The glass transition temperature (Tg) of the epoxy resin composite material obtained by curing the liquid composition to have a gel fraction of 80% or more was measured by a thermomechanical analyzer (TMA). Specifically, the measurement was performed with the same apparatus and under the same conditions as in the evaluation of the thermal expansion coefficient, and a graph in which the temperature is the X axis and the linear expansion coefficient is the Y axis was created. CTE' 1 was determined from the slope of the tangent line at 15 to 75°C in this graph, CTE' 2 was determined from the slope of the tangent line at 150 to 200°C, and the glass transition temperature Tg (°C) was determined from the intersection of CTE' 1 and CTE' 2.

### [Example 4]

In a cup, 13 g of the epoxy resin, 17 g of the curing agent, 59 g of the zeolite filler A1, 10 g of the silica filler B, and 1 g of the dispersant A were weighed and mixed so as to obtain the mix proportion shown in Table 2. Thereafter, the mixture was mixed at 1500 rpm for 5 minutes using a vacuum mixer ("V-mini 300" manufactured by EME Corporation) to prepare a liquid composition. The viscosity of this liquid composition at 23°C was measured with a rotational viscosimeter. Thereafter, the liquid composition was cast into a mold and heated at 80°C for 2 hours, and then heated at 120°C for 2 hours to be cured to have a gel fraction of 80% or more, and then removed from the mold to obtain an epoxy resin composite material.

### [Comparative Example 3]

In a cup, 21 g of the epoxy resin, 29 g of the curing agent, and 50 g of the silica filler A were weighed and mixed by hand so as to obtain the mix proportion shown in Table 2. A liquid composition and a resin composite material were obtained in the same manner as in Example 4 except for the blending ratio.

### [Comparative Example 4]

In a cup, 17 g of the epoxy resin, 23 g of the curing agent, and 60 g of the zeolite filler B were weighed and mixed by hand so as to obtain the mix proportion shown in Table 2. A liquid composition and a resin composite material were obtained in the same manner as in Example 4 except for the blending ratio.

### [Example 5]

In a cup, 21 g of the epoxy resin, 29 g of the curing agent, and 50 g of the zeolite filler A1 were weighed and mixed by hand so as to obtain the mix proportion shown in Table 2. A liquid composition and a resin composite material were obtained in the same manner as in Example 4 except for the blending ratio.

### [Example 6]

In a cup, 17.2 g of the epoxy resin, 23.2 g of the curing agent, and 59.6 g of the zeolite filler A1 were weighed and mixed by hand so as to obtain the mix proportion shown in Table 2. A liquid composition and a resin composite material were obtained in the same manner as in Example 4 except for the blending ratio.

### [Example 7]

In a cup, 17 g of the resin, 23 g of the curing agent, 59 g of the zeolite filler A1, and 1 g of the dispersant C were weighed and mixed so as to obtain the mix proportion shown in Table 2. A liquid composition and a resin composite material were obtained in the same manner as in Example 4 except for the blending ratio.

### [Example 8]

In a cup, 17 g of the epoxy resin, 23 g of the curing agent, 59 g of the zeolite filler A1, and 1 g of the dispersant A were weighed and mixed so as to obtain the mix proportion shown in Table 2. A liquid composition and a resin composite material were obtained in the same manner as in Example 4 except for the blending ratio.

### [Example 9]

In a cup, 17 g of the epoxy resin, 23 g of the curing agent, 59 g of the zeolite filler A1, and 1 g of the dispersant B were weighed and mixed so as to obtain the mix proportion shown in Table 2. A liquid composition and a resin composite material were obtained in the same manner as in Example 4 except for the blending ratio.

### [Example 10]

In a cup, 9.9 g of the epoxy resin, 14.9 g of the curing agent, 49.5 g of the zeolite filler A1, 24.7 g of the silica filler B, and 1 g of the dispersant A were weighed and mixed by hand so as to obtain the mix proportion shown in Table 2. A liquid composition and a resin composite material were obtained in the same manner as in Example 4 except for the blending ratio.

The viscosities of the liquid compositions in Examples 4 to 10 and Comparative Examples 3 and 4 were measured, and the average thermal expansion coefficients (CTE1) and the glass transition temperatures Tg of the epoxy resin composite materials were measured. The results are shown in Table 2.

**Table 2**

| | | Comparative Example | | Example | | | | | | |
|---|---|---|---|---|---|---|---|---|---|---|
| | | 3 | 4 | 5 | 6 | 7 | 8 | 9 | 4 | 10 |
| Mix proportion of liquid composition (% by mass) | Silica filler A | 50.0 | 0.0 | 0.0 | 0.0 | 0.0 | 0.0 | 0.0 | 0.0 | 0.0 |
| | Zeolite filler A1 | 0.0 | 0.0 | 50.0 | 59.6 | 59.0 | 59.0 | 59.0 | 59.0 | 49.5 |
| | Zeolite filler B | 0.0 | 60.0 | 0.0 | 0.0 | 0.0 | 0.0 | 0.0 | 0.0 | 0.0 |
| | Silica filler B | 0.0 | 0.0 | 0.0 | 0.0 | 0.0 | 0.0 | 0.0 | 10.0 | 24.7 |
| | Epoxy resin | 21.0 | 17.0 | 21.0 | 17.2 | 17.0 | 17.0 | 17.0 | 13.0 | 9.9 |
| | Curing agent | 29.0 | 23.0 | 29.0 | 23.2 | 23.0 | 23.0 | 23.0 | 17.0 | 14.9 |
| | Dispersant A | 0.0 | 0.0 | 0.0 | 0.0 | 0.0 | 1.0 | 0.0 | 1.0 | 1.0 |
| | Dispersant B | 0.0 | 0.0 | 0.0 | 0.0 | 0.0 | 0.0 | 1.0 | 0.0 | 0.0 |
| | Dispersant C | 0.0 | 0.0 | 0.0 | 0.0 | 1.0 | 0.0 | 0.0 | 0.0 | 0.0 |
| Physical properties | CTE1 (ppm/K) | 44 | 19 | 25 | 19 | 21 | 27 | 25 | 17 | 15 |
| | Viscosity (Pa -s) | 1 | 450 | 5 | 90 | 95 | 13 | 19 | 20 | 26 |
| | Tg (°C) | 160 | 150 | 155 | 150 | 125 | 115 | 115 | 110 | 110 |

### [Comparative Example 5]

A liquid composition and a resin composite material were obtained in the same manner as in Example 6, except that the zeolite filler was not used. The liquid composition had a viscosity of 0.4 Pa ·s, and the epoxy resin composite material had an average thermal expansion coefficient (CTE1) of 64 ppm/K.

### [Example 11]

A liquid composition and a resin composite material were obtained in the same manner as in Example 6, except that the zeolite filler A3 was used in place of the zeolite filler A1. The epoxy resin composite material had an average thermal expansion coefficient (CTE1) of 20 ppm/K.

### [Reference Example 1]

A liquid composition and a resin composite material were obtained in the same manner as in Example 6, except that the zeolite filler A4 was used in place of the zeolite filler A1. The epoxy resin composite material had an average thermal expansion coefficient (CTE1) of 30 ppm/K.

From Examples 5 to 11, it was confirmed that by containing the zeolite according to the present invention, a liquid composition having a low viscosity can be obtained, and the thermal expansion coefficient of the resin composite material obtained by curing the liquid composition can be reduced. In particular, from the comparison between Examples 5 and 11 containing the zeolite of Example 1 or 3 and Reference Example 1 containing the zeolite of Comparative Example 1, it was confirmed that by containing the zeolite according to the present invention, a resin composite material having a low thermal expansion coefficient can be obtained.

Further, as is clear from the results in Table 2, the resin composite materials of Examples 5 and 6 containing the zeolite according to the present invention had lower thermal expansion coefficients than the resin composite material of Comparative Example 3 containing the silica filler having a large particle size. In addition, the liquid compositions of Examples 5 and 6 containing the zeolite according to the present invention had lower viscosities than the liquid composition of Comparative Example 4 containing the zeolite having a small particle size. That is, it was confirmed that a liquid composition having a low viscosity can be obtained by containing the zeolite according to the present invention, and the thermal expansion coefficient of the resin composite material obtained by curing the liquid composition can be lowered.

In Examples 4 and 10, by using the large particle size zeolite and the small particle size inorganic filler in combination, the viscosity of the liquid composition can be reduced while lowering the thermal expansion coefficient of the epoxy resin composite material obtained by curing the liquid composition. On the other hand, in Comparative Example 3, when the large particle size silica filler was contained and the content thereof was set to the same level as that of the large particle size zeolite of Example 10, the viscosity of the liquid composition was reduced, but the average thermal expansion coefficient (CTE1) was increased.

In addition, in Examples 5 and 10, the large particle size zeolite was contained in the same amount, but in both cases, the average thermal expansion coefficient (CTE1) was lowered to some extent, and the viscosity was also reduced. In particular, Example 10 had a lower average thermal expansion coefficient (CTE1) than Example 5.

In Comparative Example 4 and Example 6, when the zeolite filler was contained and the content thereof was further increased from Comparative Example 3 and Example 5, the average thermal expansion coefficient (CTE1) was reduced. Here, in Example 6, the viscosity of the liquid composition was not increased as compared with Comparative Example 4, and therefore, it was considered to be suitable as an underfill material to be used by being filled in gaps. That is, it was confirmed that a liquid composition having a low viscosity can be obtained by using the large particle size zeolite of the present invention, and a resin composite material having a low thermal expansion coefficient can be obtained by curing the liquid composition.

As shown in Table 2, when Examples 8 and 9 were compared with Examples 6 and 7, the addition of the dispersant A or B was effective in reducing the viscosity, and thus it was confirmed that the dispersants A and B containing an amino group or an amine salt were effective in reducing the viscosity. In addition, by adding the dispersant, it can be said that it was confirmed that the glass transition temperature Tg of the resin composite materials of Examples 8 and 9 was sufficiently high, the thermal cycle resistance was excellent, and the average thermal expansion coefficient was suitable for an underfill material.

### [Example 12]

In a cup, 21 g of polyimide powder and 9 g of the zeolite filler A1 produced in Example 1 were weighed, mixed, and then spread in a press mold. The mold was set in a high-temperature vacuum press apparatus (manufactured by Kitagawa Seiki Co., Ltd.), and pressing was performed at a press temperature of 390°C and a press surface pressure of 8 MPa for 30 minutes, followed by demolding, thereby obtaining a molded body having a length of 11 cm, a width of 2.5 cm, and a thickness of 6 mm. The molded body was cut out from the end portion by 10 mm, and the average thermal expansion coefficient was measured. The results are shown in Table 3.

### [Comparative Example 6]

A molded body was produced in the same manner as in Example 12 except that the zeolite filler A4 produced in Comparative Example 1 was used as the zeolite, and the average thermal expansion coefficient thereof was measured. The results are shown in Table 3.

### [Comparative Example 7]

A molded body was produced in the same manner as in Example 12 except that the zeolite filler was not used, and the average thermal expansion coefficient thereof was measured. The results are shown in Table 3.

**Table 3**

| | | Example 12 | Comparative Example 6 | Comparative Example 7 |
|---|---|---|---|---|
| Mix proportion of resin composition (% by mass) | Zeolite filler A1 | 30 | 0 | 0 |
| | Zeolite filler A4 | 0 | 30 | 0 |
| | Polyimide resin | 70 | 70 | 100 |
| Physical properties | CTE 1 (ppm/K) | 29 | 33 | 41 |

It was confirmed from Table 3 that a resin composite material having a low thermal expansion coefficient can be obtained by using the large particle size zeolite of the present invention also for a polyimide resin.

### Industrial Applicability

According to the present invention, it is possible to provide a liquid composition having a low viscosity. Further, by curing the liquid composition, it is possible to provide a resin composite material having a low thermal expansion coefficient. In other words, according to the composition of the present invention, it is possible to obtain a sealing material having excellent injectability and excellent heat resistance, and is particularly useful as an underfill material.

Further, the resin composite material having a low thermal expansion coefficient according to the present invention is also useful as a sealing material produced by press molding or the like.

## Claims

1. Aliquid composition comprising a resin and an inorganic filler, wherein the inorganic filler comprises a zeolite having a particle size of 1.0 µm or more and 10 µm or less and an inorganic filler having a particle size of 0.1 µm or more and less than 1.0 µm.

2. The liquid composition according to claim 1, further comprising a dispersant having at least one functional group of an amino group and an amine salt.

3. The liquid composition according to claim 1 or 2, wherein the zeolite has d6r as CBU.

4. The liquid composition according to any one of claims 1 to 3, wherein the zeolite is an aluminosilicate.

5. The liquid composition according to any one of claims 1 to 4, wherein the resin is an epoxy resin.

6. The liquid composition according to any one of claims 1 to 5, wherein the resin is an epoxy resin, and the liquid composition has a viscosity at 23°C of 0.1 Pa ·s or more and 250 Pa ·s or less.

7. A liquid sealing agent comprising the liquid composition according to any one of claims 1 to 6.

8. A resin composite material obtained by curing the liquid composition according to any one of claims 1 to 6 to have a gel fraction of 80% or more.

9. A resin composite material comprising a resin and an inorganic filler, wherein the inorganic filler comprises a zeolite having a particle size of 1.0 µm or more and 10 µm or less and an inorganic filler having a particle size of 0.1 µm or more and less than 1.0 µm.

10. The resin composite material according to claim 9, further comprising a dispersant having at least one functional group of an amino group and an amine salt.

11. The resin composite material according to claim 9 or 10, wherein the zeolite has d6r as CBU.

12. The resin composite material according to any one of claims 9 to 11, wherein the zeolite is an aluminosilicate.

13. The resin composite material according to any one of claims 9 to 12, wherein the resin is at least one selected from the group consisting of an epoxy resin and a polyimide resin.

14. The resin composite material according to any one of claims 9 to 13, wherein the resin is an epoxy resin, and an average thermal expansion coefficient obtained by the following method is 0 ppm/K or more and 200 ppm/K or less (wherein the average thermal expansion coefficient is obtained from a slope of a tangent line obtained by measuring a temperature change of a change amount of sample lengths at 25 to 100°C by a compression method based on thermomechanical analysis in accordance with JIS K 7197 (2012)).

15. A zeolite which is a spherical aluminosilicate having a particle size of 1.0 µm or more and 10 µm or less, and having d6r as CBU.

16. A zeolite which is an aluminosilicate having a particle size of 1.0 µm or more and 10 µm or less, having d6r as CBU, and having a c-axis length of a lattice constant of 14.80 Å or less.

17. A composition comprising the zeolite of claim 15 or 16 and a resin.

18. The composition according to claim 17, wherein the resin is at least one selected from the group consisting of an epoxy resin and a polyimide resin.

19. The composition according to claim 17 or 18, further comprising an inorganic filler having a particle size of 0.1 µm or more and less than 1.0 µm.

20. The composition according to any one of claims 17 to 19, further comprising a dispersant having at least one functional group of an amino group and an amine salt.

21. The liquid composition according to any one of claims 17 to 20, wherein a content of the zeolite is 40 to 70% by mass, the resin is an epoxy resin, and the liquid composition has a viscosity at 23°C of 1 Pa ·s or more and 30 Pa -s or less.

22. A resin composite material comprising the composition according to any one of claims 17 to 20, wherein a content of the zeolite is 40 to 70% by mass, the resin is an epoxy resin, and an average thermal expansion coefficient at 25 to 100°C is 10 to 30 ppm/K.

23. A sealing material comprising the resin composite material according to any one of claims 9 to 14 and 22.

24. An electronic device comprising the resin composite material according to any one of claims 9 to 14 and 22.

25. A method for manufacturing a sealing material, comprising filling a gap with the liquid composition according to any one of claims 1 to 6 and 21, and then curing the liquid composition.

26. A method for producing a zeolite, comprising a step of hydrothermally synthesizing a raw material composition containing a silicon atom raw material, a water-soluble aluminum atom raw material, an organic structure directing agent, and water, and a step of subsequently firing the raw material composition, wherein the raw material composition contains 0.05 mol or less of alkali metal atoms other than the organic structure directing agent with respect to 1 mol of Si atoms.
